(19)

Europäisches
Patentamt
European
Patent Office
Office européen
des brevets

(11) **EP 4 141 490 A1**

(12) **EUROPEAN PATENT APPLICATION**
published in accordance with Art. 153(4) EPC

(43) Date of publication:
**01.03.2023 Bulletin 2023/09**

(21) Application number: **20935716.9**

(22) Date of filing: **15.05.2020**

(51) International Patent Classification (IPC):
**G01S 19/43** [(2010.01)]

(52) Cooperative Patent Classification (CPC):
**G01S 19/43**

(86) International application number:
**PCT/CN2020/090446**

(87) International publication number:
**WO 2021/226986 (18.11.2021 Gazette 2021/46)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Huawei Technologies Co., Ltd.**
**Longgang District,**
**Shenzhen,**
**Guangdong 518129 (CN)**

(72) Inventors:
• **WANG, Kang**
**Shenzhen, Guangdong 518129 (CN)**
• **HUANG, Wei**
**Shenzhen, Guangdong 518129 (CN)**
• **DONG, Guangli**
**Shenzhen, Guangdong 518129 (CN)**

(74) Representative: **Isarpatent**
**Patent- und Rechtsanwälte Barth**
**Charles Hassa Peckmann & Partner mbB**
**Friedrichstrasse 31**
**80801 München (DE)**

(54) **POSITIONING METHOD, POSITIONING CHIP, AND TERMINAL DEVICE**

(57)    A positioning method and apparatus are provided, where the method is applied to a terminal device, and the terminal device includes a positioning chip (130) and a system on chip SoC chip (120). The method includes: receiving, by the positioning chip (130), a satellite signal transmitted by at least one satellite (101); obtaining, by the positioning chip (130) by using the SoC chip (120), a differential correction value sent by a reference station (102); and performing, by the positioning chip (130) based on a carrier phase differential technology, positioning calculation by using the satellite signal and the differential correction value (103). The carrier phase differential technology is an RTK technology. This method provides a new RTK architecture based on the positioning chip (130) of the terminal device. A mobile phone corrects a coarse positioning result by using the carrier phase differential technology, so that positioning precision reaches a sub-meter level, to further improve performance in the mobile phone positioning and navigation field, and meet user requirements.

FIG. 5

EP 4 141 490 A1

**Description**

**TECHNICAL FIELD**

This application relates to the field of satellite positioning technologies, and in particular, to a positioning method, a positioning chip, and a terminal device.

**BACKGROUND**

With the development of science and technology, mobile phone positioning and navigation applications, such as in-vehicle navigation, DiDi, electronic toll collection (Electronic Toll Collection, ETC), and virtual mobile phone games, are increasingly widespread. For in-vehicle navigation, lane-level positioning precision is required to prompt a vehicle to turn, or get on or off an elevated highway. For taxis, a position of a user needs to be known precisely. These application scenarios require increasingly high precision of mobile phone positioning and navigation.

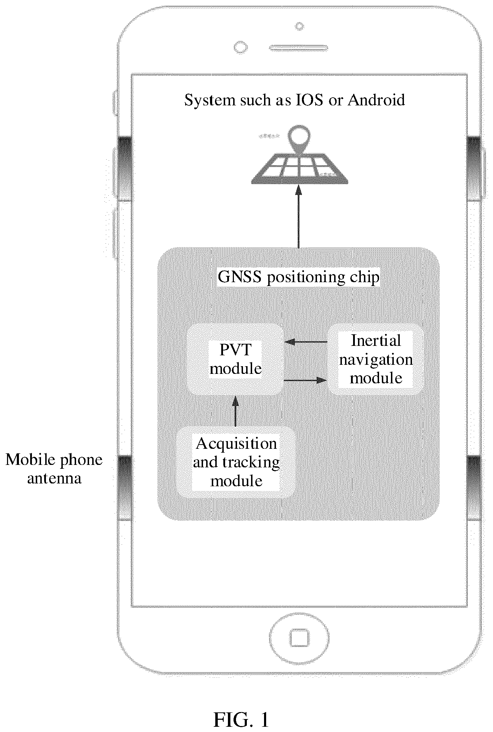

For a conventional mobile phone positioning technology, a chip structure shown in FIG. 1 is generally used. For example, a global navigation satellite system (global navigation satellite system, GNSS) positioning chip includes a PVT module, an inertial navigation module, an acquisition and tracking module, and the like. The PVT represents a position, a velocity, and a time (Position, Velocity, Time) in navigation. The GNSS positioning chip receives global positioning system (Global Positioning System, GPS), Beidou, Galileo satellite navigation system (Galileo satellite navigation system), GLONASS (GLONASS) system, or other satellite signals by using a mobile phone antenna, acquires and tracks the received satellite signals, and generates necessary measurement information such as a pseudorange observation value for use by the PVT module. The PVT module is mainly configured to perform calculation on a position, a velocity, and a time of a mobile phone terminal, and transmit information such as the position and the velocity to an operating system, such as an Apple (IOS) system or an Android (Android) system, of the mobile phone after the calculation. In addition, the inertial navigation module may be configured to perform data exchange and assistance with the PVT module by using measurement parameters reported by sensors such as a velocimeter and an accelerometer, to further improve navigation performance of the mobile phone.

In a current mobile phone positioning solution, positioning is implemented by using the pseudorange observation value output by the GNSS positioning chip. The solution is relatively simple in implementation, but has low precision that positioning precision can be determined only to a granularity of several meters, which cannot meet requirements for high-precision positioning and navigation.

**SUMMARY**

This application provides a positioning method and apparatus, to improve precision of mobile phone positioning and meet user requirements. Specifically, the following technical solutions are disclosed:

According to a first aspect, this application provides a positioning method. The method may be applied to a terminal device, the terminal device includes a positioning chip and a system on chip SoC chip, and further, the method includes: The positioning chip receives a satellite signal transmitted by at least one satellite, obtains, by using the SoC chip, a differential correction value sent by a reference station, and performs, based on a carrier phase differential technology, positioning calculation by using the satellite signal and the differential correction value.

The carrier phase differential technology is an RTK technology, and the positioning chip is a GNSS positioning chip.

This method proposes a new RTK architecture based on a mobile phone GNSS positioning chip. The terminal device corrects a coarse positioning result by using the carrier phase differential technology, so that positioning precision reaches a sub-meter level, to further improve performance in the mobile phone positioning and navigation field, and meet user requirements.

With reference to the first aspect, in a possible implementation of the first aspect, after the positioning chip receives the satellite signal transmitted by the at least one satellite, the method further includes: The positioning chip performs synchronization detection on the satellite signal, and tracks, after completing the synchronization detection, the satellite signal by using a tracking loop, to obtain carrier phase tracking information of the satellite signal. The performing positioning calculation by using the satellite signal and the differential correction value includes: The positioning chip performs positioning calculation by using the carrier phase tracking information of the satellite signal and the differential correction value, to obtain position information of the terminal device. The position information is precise position information. The carrier phase tracking information includes a carrier phase measurement value.

The received satellite signal includes a first satellite signal and a second satellite signal. Specifically, the first satellite signal is a conventional satellite signal, and the second satellite signal is a modern satellite signal.

With reference to the first aspect, in another possible implementation of the first aspect, when the satellite signal transmitted by the at least one satellite includes a first satellite signal, the first satellite signal is a conventional satellite signal, and the foregoing step of tracking, after completing the synchronization detection, the satellite signal by using a tracking loop, to obtain carrier phase tracking information of the satellite signal includes:

determining, after completing the synchronization detection, whether there is a navigation message assisting in tracking; and if there is a navigation message assisting in tracking, tracking the first satellite signal by using the first tracking loop, where the first tracking loop includes a four-quadrant phase detector, and a first carrier phase measurement value is output after the first satellite signal passes through the four-quadrant phase detector. In addition, before the positioning chip performs positioning calculation by using the carrier phase tracking information of the satellite signal and the differential correction value, the method further includes: The positioning chip determines, based on the first carrier phase measurement value, whether a cycle slip occurs in a carrier phase, and if no cycle slip occurs, performs the foregoing step of performing positioning calculation by using the carrier phase tracking information of the satellite signal and the differential correction value.

In this implementation, a differential operation is performed on the carrier phase by using a differential positioning principle, to compensate for an error generated during coarse positioning. Then, the satellite signal is tracked by using the four-quadrant phase detector, to enlarge a phase detection range, avoiding a case in which a 180° phase ambiguity is generated during phase tracking due to a limitation of a pull-in range of a two-quadrant phase detector tracking loop, so that a phase of a duplicate carrier is incorrectly adjusted in an opposite direction. Finally, a cycle slip or half cycle slip problem generated during duplication of a receiver is resolved by cycle slip and half cycle slip repair.

With reference to the first aspect, in still another possible implementation of the first aspect, the method further includes: after the positioning chip completes the synchronization detection, if there is no navigation message assisting in tracking, tracking the first satellite signal by using a second tracking loop, where the second tracking loop includes a two-quadrant phase detector, and a second carrier phase measurement value is output after the first satellite signal passes through the two-quadrant phase detector. In addition, before the positioning chip performs positioning calculation by using the carrier phase tracking information of the satellite signal and the differential correction value, the method further includes:

The positioning chip determines, based on the second carrier phase measurement value, whether a cycle slip occurs in the carrier phase; if no cycle slip occurs in the carrier phase, queries for a demodulated frame header of a navigation message in the first satellite signal to determine whether the frame header is in phase with an actual navigation message frame header; and if the frame header is in phase with the actual navigation message frame header, performs the foregoing step that the positioning chip performs positioning calculation by using the carrier phase tracking information of the satellite signal and the differential correction value.

With reference to the first aspect, in still another possible implementation of the first aspect, the method further includes: If determining that the frame header is not in phase with the actual navigation message frame header, the positioning chip performs phase compensation, for example, compensation of adding a 0.5 cycle phase, on the second carrier phase measurement value to obtain a third carrier phase measurement value. In addition, the foregoing step of performing positioning calculation by using the carrier phase tracking information of the satellite signal and the differential correction value includes: performing positioning calculation by using the third carrier phase measurement value and the differential correction value.

In this implementation, the carrier phase tracking information is recorded during carrier phase tracking, and a cycle slip problem generated by the carrier phase measurement value is resolved by detecting whether a cycle slip occurs in the carrier phase. In addition, for half cycle slip repair, a 0.5 cycle phase is added for compensation when it is detected that a half cycle slip occurs in the carrier phase measurement value subsequently. In this way, a 180° phase ambiguity generated when the phase is unlocked is overcome, and a half cycle slip problem generated during duplication of the positioning chip is resolved.

With reference to the first aspect, in still another possible implementation of the first aspect, when the satellite signal transmitted by the at least one satellite includes a second satellite signal, the second satellite signal is a modern satellite signal, and the tracking, after completing the synchronization detection, the satellite signal by using a tracking loop, to obtain carrier phase tracking information of the satellite signal includes: tracking the second satellite signal by using a first tracking loop, where the first tracking loop includes a four-quadrant phase detector, and a fourth carrier phase measurement value is output after the second satellite signal passes through the four-quadrant phase detector. In addition, before the positioning chip performs positioning calculation by using the carrier phase tracking information of the satellite signal and the differential correction value, the method further includes: determining, based on the fourth carrier phase measurement value, whether a cycle slip occurs in a carrier phase, and if no cycle slip occurs, performing the foregoing step of performing positioning calculation by using the carrier phase tracking information of the satellite signal and the differential correction value.

In this implementation, in the process of tracking and processing the modern satellite signal, because the modern satellite signal has a data channel and a pilot channel, it is unnecessary to determine whether there is a navigation message assisting in tracking as in the process of tracking the conventional satellite signal, but instead, the pilot channel is directly processed. After the positioning chip detects that bit synchronization of the modern satellite signal is completed, the signal may be directly tracked by using the four-quadrant phase detector, to determine the carrier phase measurement value of the satellite signal.

With reference to the first aspect, in still another possible implementation of the first aspect, after the positioning chip receives the satellite signal transmitted by the at least one satellite, the method further includes: The positioning chip performs demodulation processing on the received satellite signal to obtain coarse position information of the terminal device; and sends the coarse position information to the reference station, so that the reference station feeds back the differential correction value based on the coarse position information.

The differential correction value includes a carrier phase measurement value of a common-view satellite signal, and the common-view satellite signal is a satellite signal jointly tracked by the terminal device and the reference station. The foregoing step that the positioning chip performs positioning calculation by using the carrier phase tracking information of the satellite signal and the differential correction value includes: The positioning chip performs differential calculation by using the carrier phase measurement value of the common-view satellite signal and the first carrier phase measurement value to obtain a first cycle integer ambiguity; determines a corrected carrier phase measurement value by using the first cycle integer ambiguity; and performs positioning calculation based on the corrected carrier phase measurement value to obtain the position information of the terminal device. The position information is precise position information.

In this implementation, the RTK technology is used to obtain the corrected carrier phase measurement value by using the carrier phase measurement value sent by the reference station and the first carrier phase measurement value output by the tracking loop of the positioning chip, and the corrected carrier phase measurement value is used to perform positioning calculation. In this way, positioning precision of the terminal device is improved.

According to a second aspect, this application further provides a positioning apparatus, for example, a positioning chip. The positioning chip includes a transceiver circuit and a processing circuit. Further, the transceiver circuit is configured to receive a satellite signal transmitted by at least one satellite. The processing circuit is configured to obtain, by using a system on chip SoC chip, a differential correction value sent by a reference station, and perform, based on a carrier phase differential technology, positioning calculation by using the satellite signal and the differential correction value.

With reference to the second aspect, in a possible implementation of the second aspect, the processing circuit is further configured to implement the following functions: after the transceiver circuit receives the satellite signal transmitted by the at least one satellite, performing synchronization detection on the satellite signal, and tracking, after completing the synchronization detection, the satellite signal by using a tracking loop, to obtain carrier phase tracking information of the satellite signal; and performing positioning calculation by using the carrier phase tracking information of the satellite signal and the differential correction value, to obtain position information of the terminal device.

With reference to the second aspect, in another possible implementation of the second aspect, when the received satellite signal transmitted by the at least one satellite includes a first satellite signal, the processing circuit is further configured to implement the following functions:

determining, after completing the synchronization detection, whether there is a navigation message assisting in tracking; and if there is a navigation message assisting in tracking, tracking the first satellite signal by using a first tracking loop, where the first tracking loop includes a four-quadrant phase detector, and a first carrier phase measurement value is output after the first satellite signal passes through the four-quadrant phase detector; and before performing positioning calculation, determining, based on the first carrier phase measurement value, whether a cycle slip occurs in a carrier phase, and if no cycle slip occurs, performing positioning calculation by using the carrier phase tracking information of the satellite signal and the differential correction value.

With reference to the second aspect, in still another possible implementation of the second aspect, the processing circuit is further configured to implement the following functions: after completing the synchronization detection, if there is no navigation message assisting in tracking, tracking the first satellite signal by using the second tracking loop, where the second tracking loop includes a two-quadrant phase detector, and a second carrier phase measurement value is output after the first satellite signal passes through the two-quadrant phase detector; and

before the processing circuit performs positioning calculation, determining, based on the second carrier phase measurement value, whether a cycle slip occurs in the carrier phase; if no cycle slip occurs in the carrier phase, querying for a demodulated frame header of a navigation message in the first satellite signal to determine whether the frame header is in phase with an actual navigation message frame header; and if the frame header is in phase with the actual navigation message frame header, performing positioning calculation by using the carrier phase tracking information of the satellite signal and the differential correction value.

With reference to the second aspect, in still another possible implementation of the second aspect, the processing circuit is further configured to implement the following functions: when determining that the frame header is not in phase with the actual navigation message frame header, performing phase compensation on the second carrier phase measurement value to obtain a third carrier phase measurement value; and performing positioning calculation by using the third carrier phase measurement value and the differential correction value.

With reference to the second aspect, in still another possible implementation of the second aspect, when the received satellite signal transmitted by the at least one satellite includes a second satellite signal, the processing circuit is further configured to implement the following functions: tracking the second satellite signal by using a first tracking loop, where the first tracking loop includes a four-quadrant phase detector, and a fourth carrier phase measurement value is output after the second satellite signal passes through the four-quadrant phase detector; and before performing positioning calculation, determining, based on the fourth carrier phase measurement value, whether a cycle slip occurs in a carrier phase, and if no cycle slip occurs, performing positioning calculation by using the carrier phase tracking information of the satellite signal and the differential correction value.

With reference to the second aspect, in still another possible implementation of the second aspect, the processing circuit is further configured to implement the following functions: after the satellite signal transmitted by the at least one satellite is received, performing demodulation processing on the received satellite signal to obtain coarse position information of the terminal device; and sending the coarse position information to the reference station, so that the reference station feeds back the differential correction value based on the coarse position information.

The differential correction value includes a carrier phase measurement value of a common-view satellite signal, and the common-view satellite signal is a satellite signal jointly tracked by the positioning chip and the reference station. The processing circuit is further configured to implement the following functions: performing differential calculation by using the carrier phase measurement value of the common-view satellite signal and the first carrier phase measurement value to obtain a first cycle integer ambiguity; determining a corrected carrier phase measurement value by using the first cycle integer ambiguity; and performing positioning calculation based on the corrected carrier phase measurement value to obtain the position information of the terminal device.

According to a third aspect, this application provides a tracking loop, including: a control circuit, a four-quadrant phase detector, a phase-locked loop, a loop filter, a voltage-controlled oscillator, and a first switch. One end of the first switch is connected to the control circuit, and the other end is connected to the four-quadrant phase detector. The four-quadrant phase detector is sequentially connected to the loop filter and the voltage-controlled oscillator. When there is a navigation message assisting in tracking a satellite signal, the control circuit controls the first switch to be closed, to track the satellite signal by using a first tracking loop including the four-quadrant phase detector, the loop filter, and the voltage-controlled oscillator.

In addition, with reference to the third aspect, in a possible implementation of the third aspect, the tracking loop further includes a two-quadrant phase detector and a second switch. In addition, one end of the second switch is connected to the control circuit, and the other end is connected to the two-quadrant phase detector. The two-quadrant phase detector is sequentially connected to the loop filter and the voltage-controlled oscillator. When there is no navigation message assisting in tracking a satellite signal, the control circuit controls the second switch to be closed and the first switch to be open, to track the satellite signal by using a second tracking loop including the two-quadrant phase detector, the loop filter, and the voltage-controlled oscillator.

According to a fourth aspect, this application further provides a terminal device, including a positioning chip and a SoC chip. The positioning chip and the SoC chip may be connected by using an interface. Specifically, the SoC chip is configured to receive a differential correction value sent by a reference station, and send the differential correction value to the positioning chip. The positioning chip includes a processing circuit, and the processing circuit is configured to perform, based on a carrier phase differential technology, positioning calculation by using a satellite signal and the differential correction value. The satellite signal may be obtained by using a transceiver. The satellite signal is a satellite signal transmitted by at least one satellite.

The processing circuit may be the processing circuit in any one of the third aspect and the implementations of the third aspect, and when the processing circuit executes a computer program stored in a memory, the positioning method in any one of the first aspect and the implementations of the first aspect may be implemented.

According to a fifth aspect, this application further provides a computer-readable storage medium. The storage medium stores instructions, so that when the instructions are run on a computer or a processor, the method in the first aspect and the implementations of the first aspect may be performed.

In addition, this application further provides a computer program product. The computer program product includes computer instructions. When the instructions are executed by a computer or a processor, the method in the first aspect and the implementations of the first aspect may be implemented.

It should be noted that beneficial effects corresponding to the technical solutions of the implementations of the second aspect to the fifth aspect are the same as beneficial effects of the first aspect and the implementations of the first aspect. For details, refer to the beneficial effect descriptions in the first aspect and the implementations of the first aspect. Details are not described herein.

## BRIEF DESCRIPTION OF DRAWINGS

FIG. 1 is a schematic diagram of a structure of positioning using a mobile phone chip according to this application;

FIG. 2a is a schematic diagram of a composition structure of a GPS system according to this application;

FIG. 2b is a schematic diagram of a carrier phase and a phase of a ranging code according to this application;

FIG. 2c is a schematic diagram of a working principle of a differential GPS according to this application;

FIG. 2d is a schematic diagram of a working principle of a GPS receiver according to this application;

FIG. 2e is a schematic diagram of a structure of a phase-locked loop according to this application;

FIG. 2f is a diagram of a structure of a phase-locked loop including an I/Q demodulation mechanism according to this application;

FIG. 2g is a phasor representation diagram of I and Q signals according to this application;

FIG. 3 is a waveform diagram of carrier signal modulation according to this application;

FIG. 4 is a schematic diagram of a structure of a positioning system according to this application;

FIG. 5 is a flowchart of a positioning method according to this application;

FIG. 6A and FIG. 6B are a flowchart of tracking and processing a conventional satellite signal according to this application;

FIG. 7 is a schematic diagram of a structure of a tracking loop according to this application;

FIG. 8 is a waveform diagram of a carrier signal with a slip according to this application;

FIG. 9 is a flowchart of tracking and processing a modern satellite signal according to this application;

FIG. 10 is a schematic diagram of a structure of a positioning chip according to this application; and

FIG. 11 is a schematic diagram of a structure of a terminal device according to this application.

## DESCRIPTION OF EMBODIMENTS

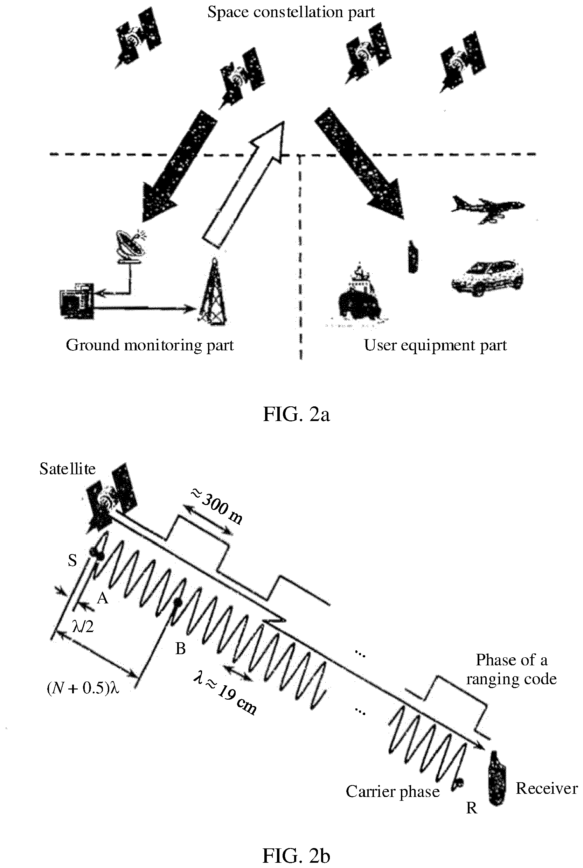

Before technical solutions of this application are described, related concepts and positioning principles are first explained and described. The following describes, in detail with reference to FIG. 2a to FIG. 2g, related concepts and principles that may appear in the technical solutions of this application.

1. Positioning system

The technical solutions of this application relate to a positioning system. The positioning system includes but is not limited to a GPS system, a GLONASS system, a Galileo satellite positioning system, and a Beidou satellite navigation system of China. In an embodiment, the GPS system is used as an example. As shown in FIG. 2a, a GPS system includes three parts: a space constellation part, a ground monitoring part, and a user equipment part. In summary, a working principle of the GPS system is described as follows: First, each GPS satellite in the space constellation part transmits a satellite signal to ground. Then, the ground monitoring part determines an orbit of the satellite by receiving and measuring each satellite signal, and transmits orbit information of the satellite to the satellite, so that the satellite relays the orbit information of the satellite in a signal transmitted by the satellite. Finally, the user equipment part receives and measures the signal of each satellite, and obtains the orbit information of the satellite from the signal, to determine a spatial position of a user receiver.

Generally, the space constellation part is unidirectionally connected to the user equipment part, that is, the GPS satellite unidirectionally transmits a satellite signal and information to the user equipment part. The space constellation part includes a plurality of satellites, such as an active satellite and a standby satellite. The ground monitoring part includes a master control station, an injection station, a monitoring station, and the like, and may be configured to collect data, monitor an orbit of a satellite, calculate a clock difference of the satellite, maintain a GPS time reference, and perform other functions. The user equipment part may be understood as a GPS receiver (or a GPS user receiver, referred to as a "receiver" for short), and is mainly configured to obtain a required measurement value and navigation information after data processing on a received satellite signal, and finally complete a positioning calculation and navigation task for a user.

2. Pseudorange

The pseudorange is a most basic distance measurement value of a GPS receiver to a satellite signal. The pseudorange may be defined as a velocity of light multiplied by a difference between a signal receiving time and a signal transmitting time. The signal receiving time is directly read from a clock of the GPS receiver, while the transmitting time obtained by the GPS receiver from the signal is related to measurement of a phase of a ranging code (C/A code) in the signal, and specifically, may be obtained by using a code tracking loop of the GPS receiver. The C/A code (coarse acquisition) may be translated into a coarse acquisition code.

Generally, a code length of a C/A code is about 300 meters, but an actual code length is equal to 293 meters, because a length of a C/A code is 1023 chips, whose code rate is 1.023*106 chips/second. Generally, a C/A code is approximated as 300 m long. Therefore, in pseudorange measurement, due to a limitation that a code tracking loop can determine a code phase only to a granularity of several meters, which results in coarse positioning precision of pseudorange measurement.

3. Carrier phase measurement value

A carrier signal has different phase values at a same moment at different positions on a propagation path of the carrier signal. As shown in FIG. 2b, a point S represents a zero phase center of a satellite signal transmitter, a point A on a carrier signal propagation path is half a wavelength (that is, 0.5λ) away from the point S, and a carrier phase of the point A keeps 180° behind a phase of the point S at any moment. For a point that is on the propagation path and that is farther away from the point S, a carrier phase of the point is more behind that of the point S. In FIG. 2b, the carrier phase of the point A is 180° behind the phase of the point S, and therefore, the point A is half the wavelength away from the point S. A distance between a point B and the point S is not 0.5λ, but (N+0.5)λ, where N is an unknown integer, N represents an integer quantity of wavelengths, and λ is the wavelength. Similarly, a distance between a satellite and a receiver may be obtained by calculating a phase difference between a carrier phase at a point R of the receiver and the carrier phase at the point S.

The receiver generates a carrier signal duplicate by using a crystal oscillator inside the receiver. A carrier phase measurement value $\phi$ may be defined as a difference between a phase $\varphi_u$ of the duplicate carrier signal of the receiver and a phase $\varphi^s$ of a satellite carrier signal received by the receiver, that is:

$$\phi = \varphi_u - \varphi^s \tag{1}$$

Each carrier phase and phase difference are measured in cycle (or wavelength). One cycle corresponds to a phase change of 360° (that is, $2\pi$ radians), and corresponds to one carrier wavelength in distance. That is, after multiplied by the wavelength λ, the carrier phase measurement value $\phi$ measured in cycle is converted into a carrier phase measurement value measured in distance. Because the phase $\varphi_u$ of the duplicate carrier signal is exactly equal to a phase of the actual satellite carrier signal at the satellite end, the carrier phase measurement value $\phi$ is a phase variation of the satellite carrier signal from the satellite end to the receiver end.

4. Cycle integer ambiguity

Assuming that carrier phase measurement is not affected by errors such as a clock difference and an atmospheric delay, based on a relationship described above between a carrier phase measurement value between two points on a signal propagation path and a distance, the carrier phase measurement value may be expressed by formula (2):

$$\phi = \lambda^{-1} r + N \tag{2}$$

where r is a geometric distance between a satellite and a receiver, N is an unknown integer, and in the GPS field, the unknown integer N is generally referred to as a cycle integer ambiguity.

If errors such as a clock difference of the receiver, a clock difference of the satellite, and an atmospheric delay are considered, the carrier phase measurement equation of formula (2) is:

$$\phi = \lambda^{-1} \left( r + c \left( \delta t_u - \delta t^s \right) - I + T \right) - N + \varepsilon_\phi \tag{3}$$

where $\phi$ is the carrier phase measurement value, λ is a wavelength, I is an ionospheric delay, T is a tropospheric delay, N is the cycle integer ambiguity, c is a velocity of light, $\varepsilon_\phi$ is noise, $\delta t_u$, is the clock difference of the receiver, and $\delta t^s$ is the clock difference of the satellite.

In embodiments of this application, the carrier phase difference measurement value is referred to as a carrier phase for short.

5. Carrier tracking loop and out of cycle

To obtain a carrier phase of a received satellite signal, a receiver actually does not duplicate a carrier whose frequency is always f, but tries to duplicate, at each moment by using a carrier tracking loop inside the receiver, a carrier consistent with a carrier of the received satellite signal in frequency or phase. In this way, the carrier tracking loop may be basically classified into two forms: a frequency-locked loop (frequency-locked loop, FLL) and phase-locked loop (phase-locked loop, PLL). Embodiments of this application mainly relate to the PLL. The PLL continuously adjusts a phase of a duplicate carrier so that the phase is consistent with the carrier phase of a received satellite signal, and then outputs an integral Doppler measurement value.

Regardless of whether a carrier phase measurement value output by the receiver is generated by the FLL or the PLL, the carrier phase measurement value always includes an unknown cycle integer ambiguity N. When the carrier tracking loop is unlocked and then relocked to the signal, the cycle integer ambiguity in the carrier phase measurement value output by the carrier tracking loop usually has a slip. In other words, the cycle integer ambiguity has different values before and after the signal is unlocked. Sometimes, although the receiver has not declared that the signal is completely unlocked, the carrier phase measurement value output by the receiver may have a full cycle or half cycle slip error. Generally, such a phenomenon in which the cycle integer ambiguity slips in the carrier phase measurement value is referred to as out of cycle.

6. Differential positioning

Differential GPS is a method that is widely applied and can effectively reduce various GPS measurement errors, and may be applied to differential GPS systems such as a wide area augmentation system (wide area augmentation system, WAAS) and a local area augmentation system (local area augmentation system, LAAS).

A basic principle of differential GPS positioning is mainly assuming, based on a spatial correlation, a time correlation, and the like of a clock error of a satellite, an ephemeris error of the satellite, an ionospheric delay, and a tropospheric delay, that the errors included in GPS measurement values of different receivers in a same region are approximately equal. Generally, one of the receivers is used as a reference, and where the receiver is located is referred to as a reference station (or a base station). Correspondingly, the receiver is referred to as a reference station receiver.

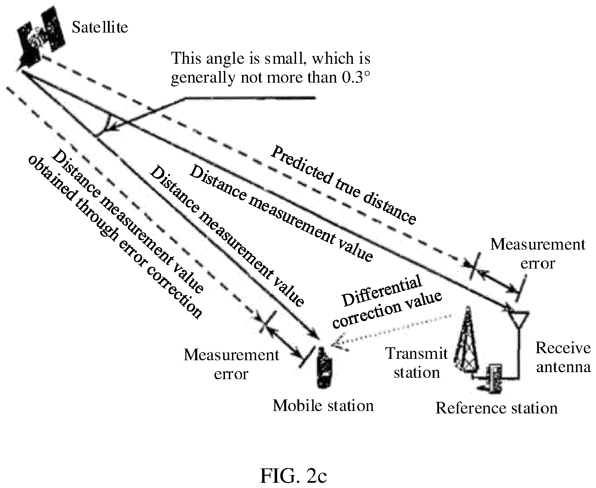

A position of the reference station receiver (referred to as a "reference station" for short below) is precisely known in advance, so that a true geometric distance from the satellite to the reference station can be calculated precisely. A difference between a distance measurement value of the reference station to the satellite and the true geometric distance is equal to a measurement error of the reference station to the satellite. Because other receivers in the same region at the same moment have correlated or similar errors in distance measurement values to the same satellite, as shown in FIG. 2c, the reference station transmits the measurement error of the receiver of the reference station to a mobile station (that is, a user receiver) through a radio wave. Then, the mobile station may use the received measurement error of the reference station to correct a distance measurement value of the mobile station to the same satellite, to improve measurement and positioning precision of the mobile station. This is a basic working principle of the differential GPS.

Optionally, such a correction value broadcast by the reference station and used to reduce or even eliminate the GPS measurement error of the mobile station is referred to as a differential correction value.

7. RTK positioning

Real time kinematic (real time kinematic, RTK) positioning is a technology of real-time dynamic relative positioning based on a carrier phase observation value. A principle of RTK positioning is sending, in real time by using a data communication link (radio station), satellite data observed by a GPS receiver located on a reference station, so that a GPS user receiver (also referred to as a mobile station) located nearby receives an electrical signal from the reference station during satellite observation, provides three-dimensional coordinates of the mobile station through real-time processing on the received signal, estimates precision of the coordinates.

For measurement with RTK, at least two GPS receivers are equipped, one is fixedly placed on a reference station and the other is used as a mobile station for point measurement. A data communication link is further required between the two receivers to send observation data on the reference station to the mobile station in real time. The mobile station processes received data (a satellite signal and a differential correction value of the reference station) in real time by using RTK software, which mainly completes calculation of a double-difference ambiguity, calculation of a baseline vector, coordinate transformation, and the like. Generally, a baseline length between a reference station and a mobile station in an RTK system should not exceed 10 km, and a position of the reference station needs to be known.

Differential GPS positioning may be classified into static positioning and dynamic positioning. For a dynamic positioning application, because the mobile station of the differential system moves relative to the reference station, a cycle integer ambiguity generally needs to be calculated quickly to complete positioning in real time, whose positioning precision can reach a centimeter level. With the RTK positioning technology, precise positioning of the mobile station can be completed in real time, which can achieve positioning precision higher than a decimeter level. The positioning precision is relatively high.

In addition, in an RTK positioning process, a double-difference cycle integer ambiguity may be obtained by using a LAMBDA (Least square AMBiguity decorrelation adjustment) algorithm.

8. Working principle of GPS receiver

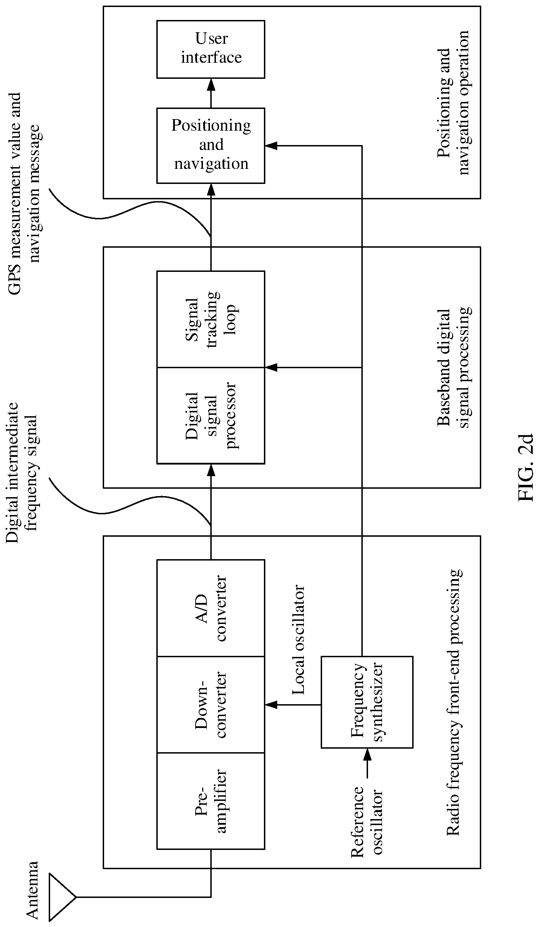

The GPS receiver, that is, a GPS user receiver, referred to as a "receiver" for short, is a mobile station or a terminal device in a differential GPS positioning system. An internal working process of the GPS receiver is shown in FIG. 2d, and generally includes three major functional modules: radio frequency (radio frequency, RF) front-end processing, baseband digital signal processing (Digital Signal Processing, DSP), and positioning and navigation operation. The radio frequency front-end processing module receives each visible GPS satellite signal by using an antenna, which is filtered and amplified by a pre-filter and a pre-amplifier, and then mixed with a sine wave local oscillator signal generated by a local oscillator to be down-converted into an intermediate frequency (Intermediate frequency, IF) signal. Finally, an analog-to-digital (Analog-to-Digital, A/D) converter converts the intermediate frequency signal into a discrete-time digital intermediate frequency signal.

Optionally, the radio frequency front-end processing module is generally integrated into an application-specific integrated circuit (application-specific Integrated circuit, ASIC) chip, and the integrated circuit may be referred to as a radio frequency integrated circuit (RF Integrated circuit, RFIC).

The baseband digital signal processing module duplicates, by using the digital intermediate frequency signal output by the radio frequency front-end, a local carrier signal consistent with the received satellite signal, to implement acquisition and tracking of the GPS signal, obtain carrier phase and other measurement values, and demodulate a navigation message.

Further, to demodulate the navigation message from the received satellite signal, at a GPS satellite signal transmit end, the GPS carrier signal is modulated with a C/A code and a navigation message data bit. Correspondingly, at a GPS signal receive end, to demodulate the navigation message data bit from the received satellite signal, the baseband digital signal processing module needs to completely strip a carrier including a Doppler frequency shift in the digital intermediate frequency signal by mixing, and then completely strip the C/A code in the signal by a C/A code correlation operation. A remaining signal is a binary phase shift keying (Bi phase shift keying, BPSK) modulated navigation message data bit.

On one hand, the GPS receiver continuously adjusts, by using a carrier tracking loop (referred to as a carrier loop for short), a carrier duplicated inside the receiver to keep a frequency (or phase) of the duplicate carrier consistent with a frequency (or phase) of the digital intermediate frequency signal, and then implements carrier stripping through down-conversion mixing. On the other hand, the receiver continuously adjusts, by using a code tracking loop (referred to as a code loop for short), a C/A code duplicated inside the receiver to keep a phase of the duplicate C/A code consistent with a phase of the C/A code in the digital intermediate frequency signal, and then implements C/A code stripping through the code correlation operation.

9. Phase-locked Loop (PLL)

To completely strip the carrier in the digital intermediate frequency input signal to down-convert the signal from the intermediate frequency to the baseband, the carrier loop includes a mixer and a carrier duplicated by the mixer needs to be consistent with an input carrier. In an implementation form, the carrier loop detects a phase difference between the duplicate carrier of the carrier loop and the input carrier and then correspondingly adjusts the phase of the duplicate carrier to keep phases of the two carriers consistent. Such a carrier loop is referred to as a phase-locked loop.

The phase-locked loop is referred to as a PLL for short, which is a carrier loop that aims to lock a phase of an input carrier signal. The phase-locked loop is an electronic control loop that generates and outputs a periodic signal, and continuously adjusts a phase of its output signal to keep the phase of the output signal consistent with that of the input signal at any time. When the phases of the input and output signals are not consistent but tending to be consistent, the phase-locked loop operates in a pull-in state, and the phase-locked loop in this case shows its transient characteristics. If a transient process does not converge or interference is excessive strong, resulting in that the phase-locked loop cannot enter a locked state, the phase-locked loop is described as transient loss of lock.

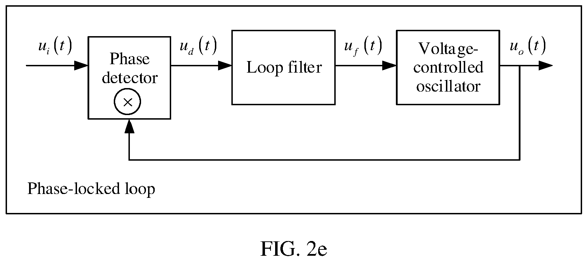

As shown in FIG. 2e, a typical phase-locked loop mainly includes three parts: a phase detector, a loop filter, and a voltage-controlled oscillator (voltage-controlled oscillator, VCO). An input signal $u_i(t)$ of the phase-locked loop and an output signal $u_o(t)$ generated by the voltage-controlled oscillator are respectively expressed as follows:

$$u_i(t) = U_i \sin(\omega_i t + \theta_i) \tag{4}$$

$$u_o(t) = U_o \sin(\omega_o t + \theta_o) \tag{5}$$

where an angular frequency $\omega_i$ and an initial phase $\theta_i$ of the input signal, and an angular frequency $\omega_o$ and an initial phase $\theta_o$ of the output signal are both functions of time. The phase detector for detecting a phase difference between the input signal $u_i(t)$ and the output signal $u_o(t)$ may be simply considered as a multiplier, and after the phase detector performs a multiplication operation on $u_i(t)$ and $u_o(t)$ , a phase detection result output signal $u_d(t)$ is equal to:

$$
\begin{aligned}
u_d(t) &= u_i(t)u_o(t) \\
&= U_i U_o \sin(\omega_i t + \theta_i)\sin(\omega_o t + \theta_o) \\
&= K_d \left\{ \sin\left[(\omega_i + \omega_o)t + \theta_i + \theta_o\right] + \sin\left[(\omega_i - \omega_o)t + \theta_i - \theta_o\right] \right\}
\end{aligned}
\tag{6}
$$

where a gain $K_d$ of the phase detector is $K_d = \dfrac{1}{2}U_i U_o$ .

After the phase-locked loop enters a locked state, the angular frequency $\omega_o$ of the output signal is very close to the angular frequency $\omega_i$ of the input signal, that is,

$$
\omega_i \approx \omega_o.
$$

Therefore, the first item on the right of the last equal sign in formula (6) is a high frequency signal component whose angular frequency is about twice , and the second item is a low frequency (or referred to as direct current) signal component in the phase detection result $u_d(t)$.

The loop filter is a low-pass filter, configured to reduce noise in the loop. After the output signal $u_d(t)$ of the phase detector passes through an ideal low-pass filter, the high frequency signal component and noise of the output signal are filtered out. Therefore, an output signal $u_f(t)$ of the filter is equal to the low frequency signal component in $u_d(t)$ , that is:

$$
u_f(t) = K_d K_f \sin\theta_e(t)
\tag{7}
$$

where the coefficient $K_f$ is a filtering gain, and the phase difference $\sin\theta_e(t)$ is a phase difference between the input signal and the output signal of the phase-locked loop. That is, $\sin\theta_e(t) = \theta_i - \theta_o$. When the signal is locked by the phase-locked loop, not only the angular frequency $\omega_o$ of the output signal is equal to $\omega_i$, but also the initial phase value $\theta_o$ of the output signal is very close to $\theta_i$, that is, a value of the phase difference $\sin\theta_e(t)$ is near zero.

10. In-phase/quadrature (I/Q) demodulation

In addition, for BPSK modulation characteristics of GPS signals, a phase-locked loop of a GPS receiver usually completes working such as carrier stripping, phase detection, and data demodulation with the help of an in-phase/quadrature (In-phase/Quadrature, I/Q) demodulation method.

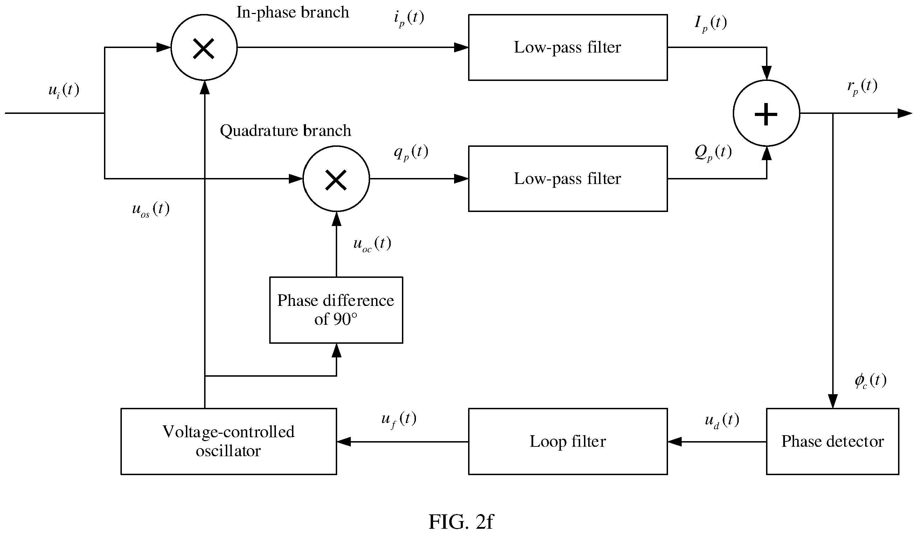

FIG. 2f shows a phase-locked loop including an I/Q demodulation mechanism. A continuous time signal $u_i(t)$ as a system input may be expressed as follows:

$$
u_i(t) = \sqrt{2}aD(t)\sin(\omega_i t + \theta_i) + n
\tag{8}
$$

where $D(t)$ represents a data bit modulated on a carrier. A difference between formula (8) and formula (4) lies in that a signal amplitude of the former is a constant, while an amplitude of the latter is $\sqrt{2}a$ multiplied by the data level $D(t)$ that includes information and that has a value of $\pm 1$. The sign of $D(t)$ varies with a slip of the data bit, and n represents white Gaussian noise with a mean value of 0 and a variance of $\delta_n^2$ .

The phase-locked loop shown in FIG. 2f duplicates sinusoidal and cosine carrier signals with a phase difference of 90° and multiplies each with the input signal to implement down-conversion (or referred to as carrier stripping) of the input signal. A loop branch that mixes the input signal and the sinusoidal carrier duplicate signal is referred to as an in-phase branch (referred to as an "I branch" for short), and another loop branch that mixes the input signal and the cosine carrier duplicate signal is referred to as a quadrature branch (referred to as a "Q branch" for short). A function of the I/Q demodulation method is to demodulate the data bit $D(t)$ from the input signal $u_i(t)$.

A phase angle $r_p(t)$ of a phasor is equal to a phase difference $\phi_c(t)$ between the input signal and the duplicate signal, that is:

$$\phi_c(t) = \arctan\left(\frac{Q_p(t)}{I_p(t)}\right) \qquad (9)$$

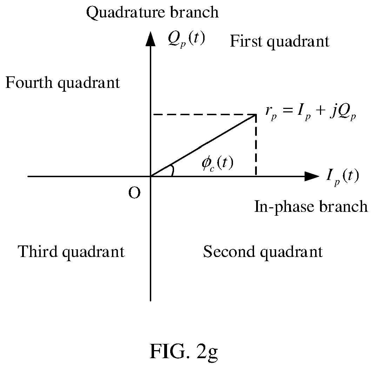

where an angle value returned by the two-quadrant arctangent function arctan ranges between $-\pi/2$ and $+\pi/2$. In a phasor diagram shown in FIG. 2g, $I_p(t)$ and $Q_p(t)$ are coordinate values on an X-axis and a Y-axis respectively, then a directed connection line from a coordinate origin O to a data point $(I_p(t) , Q_p(t))$ is the phasor $r_p(t)$ , and an angle of rotation from the X-axis to the phasor $r_p(t)$ is the phase difference $\phi_c(t)$ .

The following describes technical problems to be resolved by the technical solutions of this application.

The technical solutions in embodiments of this application are mainly used to resolve technical problems in two aspects. One aspect is using an RTK carrier phase differential technology to improve precision of mobile phone positioning and meet user requirements for high precision. The other aspect is detecting a cycle slip or a half cycle slip based on satellite signal tracking information of a chip side, and implement half cycle slip repair, to improve stability and related performance of using a carrier phase, so that the RTK carrier phase differential technology can be stably applied to mobile phones.

Specifically, the following describes a cause for the cycle slip or half cycle slip phenomena of the carrier phase in the second aspect.

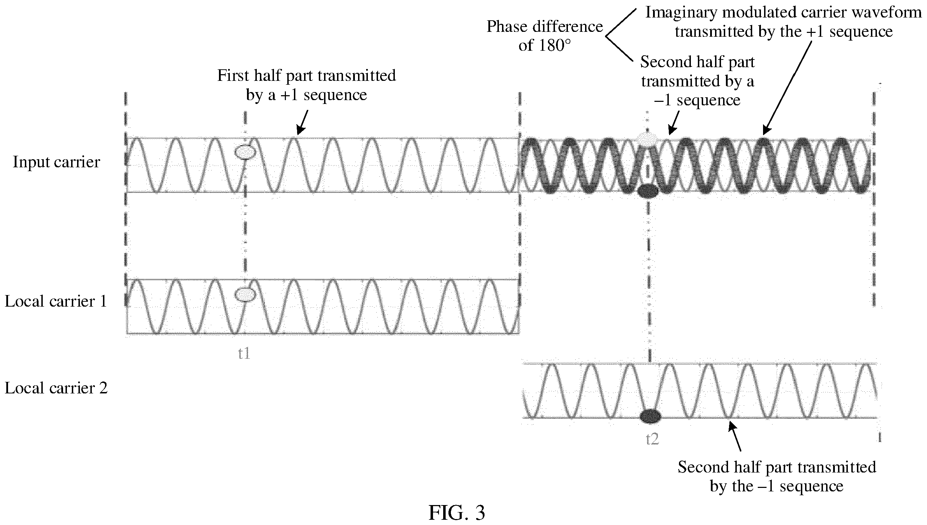

The half cycle slip is used as an example. As shown in FIG. 3, assuming that a satellite signal transmitted by a satellite includes an input carrier (Input carrier), after receiving the satellite signal, a receiver demodulates the input carrier to obtain a navigation message. The navigation message includes a random number sequence including +1 and -1. The first half part is a carrier waveform transmitted by a +1 sequence, the second half part is a carrier waveform transmitted by a real -1 sequence, and a waveform with a thick line in the second half part in FIG. 3 is an imaginary modulated carrier waveform transmitted by the +1 sequence. It can be learned that a phase difference between sequences of the first half part and the second half part is 180°, which indicates that a carrier phase is reversed during modulation. The modulation process includes modulation of a basic communication principle BPSK. A specific BPSK modulation process is not described in detail in embodiments.

When a half cycle slip occurs in the carrier phase in the BPSK modulation process of the local receiver, the carrier waveform of the +1 sequence may be represented as a local carrier 1 (Local carrier 1). The local carrier 1 is a carrier waveform duplicated on a receiver chip side. Under normal conditions, the receiver tracks a carrier and locks a correct carrier (without a 180° phase ambiguity). For the carrier waveform of the -1 sequence, that is, a local carrier 2 (local carrier 2), during carrier tracking, a duplicate waveform of the local carrier 2 is a carrier waveform in the third line shown in FIG. 3. Because the navigation message of the -1 sequence is modulated inside the receiver, there is a 180° phase ambiguity, which results in a half cycle slip (a 180° phase slip) in the carrier phase.

In this case, if the local receiver uses a two-quadrant phase detector to detect the phase, a bit slip of the +1 or -1 sequence cannot be detected because a phase detection range of the two-quadrant phase detector is limited. Therefore, both are tracked based on the waveform of the input carrier. For example, when carrier tracking is performed on the second half part of the input carrier, regardless of impact of the navigation message, modulation is performed based on the carrier waveform of the imaginary +1 sequence (thick line), but the receiver actually tracks the carrier waveform of the -1 sequence (thin line). The two differ in a 180° phase ambiguity, which affects positioning precision.

In addition, because a slip amplitude of the half cycle slip of the carrier phase is small, it is not easy to detect.

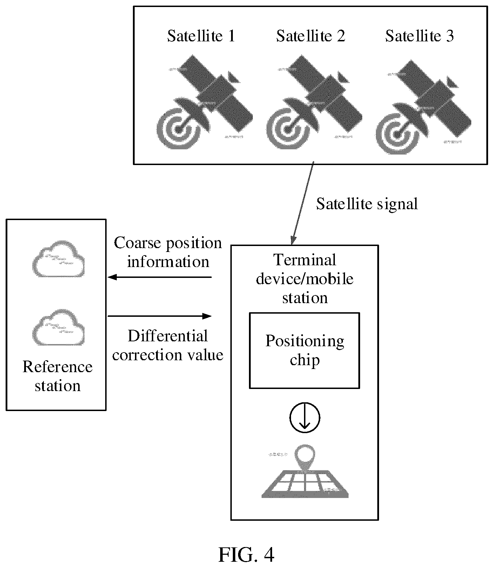

The following describes in detail the technical solutions in embodiments of this application with reference to FIG. 4 to FIG. 11.

An embodiment provides a positioning method. A carrier phase differential technology, or referred to as an RTK technology, is used to perform RTK positioning calculation by using a satellite carrier phase measurement value and a differential correction value, to improve positioning precision of a terminal device.

In a GPS system, as shown in FIG. 4, the GPS system includes a plurality of GPS satellites, a reference station, and a mobile station. A quantity of GPS satellites currently configured for positioning is not less than 3, for example, there are a satellite 1, a satellite 2, and a satellite 3. The reference station is a reference station receiver in the foregoing differential positioning system, and a position of the reference station is fixed and known.

The mobile station is a device to be positioned, and the mobile station is also a terminal device, which is located near the reference station and does not have a fixed position.

The terminal device may be user equipment (user equipment, UE), an access terminal, a user unit, a user station, a mobile station, a mobile console, a mobile device, a wireless communication device, a user agent, a user apparatus, or the like. Optionally, the terminal device may alternatively be a cellular phone, a cordless telephone set, a session initiation protocol (session initiation protocol, SIP) phone, a personal digital assistant (personal digital assistant, PDA), or a handheld device with a wireless communication function, for example, a mobile phone, a computing device, an in-vehicle device, a wearable device, a terminal device in a future 5G network, or a terminal device in a future evolved public land mobile network (public land mobile network, PLMN). A form and structure of the terminal device are not limited in this embodiment.

Further, the terminal device includes a positioning chip and a system on chip (System on Chip, SoC) chip, and the positioning chip and the SoC chip are connected by using at least one interface.

Optionally, the positioning chip is a global navigation satellite system (global navigation satellite system, GNSS) positioning chip. The GNSS positioning chip has positioning and calculation functions. The GNSS may include a GPS, a global navigation satellite system (global navigation satellite system, GLONASS), a Beidou navigation satellite system (beidou navigation satellite system, BDS), and the like.

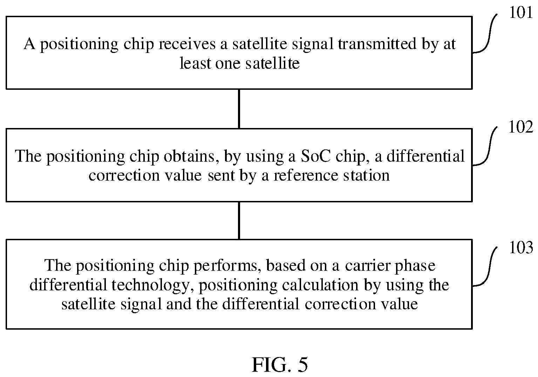

FIG. 5 is a flowchart of a positioning method according to an embodiment. The method may perform positioning for any one of the foregoing terminal devices, and the terminal device includes a positioning chip and a SoC chip. Specifically, the method includes the following steps.

101. The positioning chip receives a satellite signal transmitted by at least one satellite.

Generally, the satellite signal transmitted by the satellite may be structurally divided into three layers: a carrier, a pseudocode, and a data bit. In these three layers, the pseudocode and the data bit are first attached to a carrier in a form of a sine wave through modulation, and then the satellite broadcasts a modulated carrier signal. In addition, each GPS satellite may transmit a radio carrier signal at frequencies of two L bands (that is, L1 and L2).

The satellite signal may be classified into a first satellite signal and a second satellite signal based on the frequencies. Specifically, the first satellite signal is a conventional satellite signal, and the second satellite signal is a modern satellite signal. The conventional satellite signal generally includes satellite signals such as GPSL1C/A, Beidou B1I, and QZSSL1CA, and GPSL1C/Arepresents a satellite signal with a nominal carrier frequency of 1575.42 MHz (megahertz) in a GPS system. The modern satellite signal generally includes satellite signals such as GPSL5, GALES, and QZSSL5, and GPSL5C represents a satellite signal with a nominal carrier frequency of 1176.45 MHz in a GPS BLOCK III system. It should be understood that the satellite signal may further include signals at other frequencies.

In addition, the method further includes:

1011. The positioning chip performs demodulation processing on the satellite signal to obtain first position information of the terminal device, where the first position information is coarse position information of the terminal device.

1012. The positioning chip sends the coarse position information to a reference station.

1013. The reference station receives the coarse position information, and sends a differential correction value to the terminal device.

Specifically, the positioning chip performs PVT calculation based on information carried in the satellite signal, a measured pseudorange observation value and Doppler observation value, and ephemeris information, and then obtains the coarse position information by using a least square (least square, LSQ) algorithm. Further, a specific demodulation process includes: The positioning chip performs carrier demodulation and pseudocode despreading on the received satellite signal to obtain the data bit, and then compiles the data bit into a navigation message based on a format of the navigation message. The navigation message includes important information for positioning, such as a time, an orbit of the satellite, and an ionospheric delay. Then, the positioning chip completes coarse positioning based on the navigation message to obtain the coarse position information.

In addition, after step 101, the method further includes:

101': The positioning chip performs synchronization detection on the satellite signal, and tracks, after completing the synchronization detection, the satellite signal by using a tracking loop, to obtain carrier phase tracking information of the satellite signal, where the carrier phase tracking information includes a carrier phase measurement value.

102. The positioning chip obtains, by using the SoC chip, the differential correction value sent by the reference station.

The SoC chip is coupled to the positioning chip, the SoC chip is connected to a communication module, the communication module may receive the differential correction value from the reference station, and the SoC chip obtains the differential correction value received by the communication module and transmits the differential correction value to the positioning chip. The communication module may be a short-range communication module, and the SoC chip may communicate with another communication device by using the short-range communication module, to obtain the differential correction value forwarded by the another communication device. Alternatively, the communication module may be a transceiver, the SoC chip includes a baseband (baseband) processor coupled to the transceiver, and the baseband processor accesses a mobile communication network by using the transceiver, to obtain the differential correction value from the network. It should be understood that the reference station is generally an unattended satellite monitoring device, which can access a communication network and transmit detected data through the communication network.

The differential correction value includes a carrier phase measurement value of a common-view satellite signal and the common-view satellite signal is a satellite signal jointly tracked by the terminal device and the reference station, and comes from a same GPS satellite. In addition, the differential correction value further includes parameters such as a pseudorange observation value, a signal-to-noise ratio, an ionospheric delay, and a tropospheric delay of a common-view satellite.

In addition, before the differential correction value sent by the reference station is obtained, the method further includes: determining the reference station, to ensure that the reference station is located near the terminal device, thereby providing an accurate differential correction value for the terminal device. Specifically, the reference station may be determined by using the coarse position information sent by the terminal device.

In a possible implementation, the terminal device sends the coarse position information to a master control station, and the master control station selects, based on the coarse position information, a reference station relatively close to the terminal device. The reference station may be a virtual reference station. Then, the virtual reference station sends a differential correction value measured by the virtual reference station to the terminal device.

103. The positioning chip performs, based on a carrier phase differential technology, positioning calculation by using the satellite signal and the differential correction value.

The satellite signal refers to the carrier phase tracking information, obtained in step 101', of the satellite signal, the differential correction value refers to the carrier phase measurement value, sent by the reference station in step 102, of the common-view satellite signal, and step 103 specifically includes: The positioning chip performs positioning calculation by using the carrier phase tracking information of the satellite signal and the differential correction value, to obtain position information of the terminal device.

Specifically, the positioning chip determines a common-view satellite. The common-view satellite is a GPS satellite jointly tracked by the reference station and the terminal device, that is, a satellite signal tracked by the terminal device and the differential correction value sent by the reference station have a same satellite number. Then, the positioning chip obtains a relational expression between the carrier phase measurement value and a cycle integer ambiguity through double-difference calculation, and finally calculates the cycle integer ambiguity N based on the relational expression.

When the carrier phase differential technology, that is, the RTK technology, is used to eliminate a carrier phase measurement error in the coarse position information, a differential manner includes single-difference, double-difference, triple-difference, and other manners. In this embodiment, the double-difference is used as an example. Each double-difference measurement value relates to measurement values of two devices to two satellites at a same moment. For example, assuming that the two devices in the positioning system are the terminal device j and the reference station i, and the two common-view satellites are a satellite p and a satellite q, a relational expression for the terminal device j to obtain a carrier phase measurement value through double-difference calculation is as follows:

$$\lambda\varphi_i^p = r_i^p + c\left(\delta t_i - \delta t^p\right) - I_i^p + T_i^p - \lambda N_i^p + \varepsilon_{\varphi,i}^p \tag{10}$$

$$\lambda\varphi_j^p = r_j^p + c\left(\delta t_j - \delta t^p\right) - I_j^p + T_j^p - \lambda N_j^p + \varepsilon_{\varphi,j}^p \tag{11}$$

$$\lambda\varphi_i^q = r_i^q + c\left(\delta t_i - \delta t^q\right) - I_i^q + T_i^q - \lambda N_i^q + \varepsilon_{\varphi,i}^q \tag{12}$$

$$\lambda\varphi_j^q = r_j^q + c\left(\delta t_j - \delta t^q\right) - I_j^q + T_j^q - \lambda N_j^q + \varepsilon_{\varphi,j}^q \tag{13}$$

where for the reference station i, the terminal device j, the satellite p, and the satellite q, $\lambda$, is a carrier wavelength; $r_i^p$ is a geometric distance between the reference station i and the satellite p, $r_j^p$ is a geometric distance between the terminal device j and the satellite p, $r_i^q$ is a geometric distance between the reference station i and the satellite q, and $r_j^q$ is a distance between the terminal device j and the satellite q; I is an ionospheric delay, and T is a tropospheric delay; $N_i^p$

is a cycle integer ambiguity of the reference station i relative to the satellite p, $N_j^p$ is a cycle integer ambiguity of the terminal device j relative to the satellite p, $N_i^q$ is a cycle integer ambiguity of the reference station i relative to the satellite q, and $N_j^q$ is a cycle integer ambiguity of the terminal device j relative to the satellite q; $\varepsilon$ is noise, and c is a velocity of light; $\delta t_i$ is a clock difference of the terminal device, $\delta t^p$ is a clock difference of the satellite p, and $\delta t^q$ is a clock difference of the satellite q; and $\varphi_i^p$ is a carrier phase measurement value of the reference station i relative to the satellite p, $\varphi_j^p$ is a carrier phase measurement value of the terminal device j relative to the satellite p, $\varphi_i^q$ is a carrier phase measurement value of the reference station i relative to the satellite q, and $\varphi_j^q$ is a carrier phase measurement value of the terminal device j relative to the satellite q.

Optionally, the differential correction value in step 102 includes: the carrier phase measurement value $\varphi_i^p$ of the reference station i relative to the satellite p, the carrier phase measurement value $\varphi_i^q$ of the reference station i relative to the satellite q, the ionospheric delay I, the tropospheric delay T, and the like.

Based on the foregoing formula (10) to formula (13), the following formulas are obtained:

$$\lambda\varphi_{ij}^p = \lambda\varphi_j^p - \lambda\varphi_i^p \tag{14}$$

$$\lambda\varphi_{ij}^q = \lambda\varphi_j^q - \lambda\varphi_i^q \tag{15}$$

$$N_{ij}^p = N_j^p - N_i^p \tag{16}$$

$$N_{ij}^q = N_j^q - N_i^q \tag{17}$$

Based on formula (14) and formula (15), the following formula may be obtained: $\lambda\varphi_{ij}^{pq} = \lambda\varphi_{ij}^q - \lambda\varphi_{ij}^p$ (18)

Based on formula (16) and formula (17), the following formula may be obtained: $N_{ij}^{pq} = N_{ij}^q - N_{ii}^p$ (19)

A fixed carrier cycle integer ambiguity $N_{ij}^{pq}$ may be calculated based on formula (19), to obtain a corrected carrier phase measurement value $\varphi_{ij}^{pq}$, and positioning calculation is performed by using the corrected carrier phase measurement value $\varphi_{ij}^{pq}$, to obtain second position information of the terminal device. The second position information is precise position information of the terminal device.

This method proposes a new RTK architecture based on a mobile phone GNSS positioning chip. The terminal device corrects a coarse positioning result by using the carrier phase differential technology, so that positioning precision reaches a sub-meter level, to further improve performance in the mobile phone positioning and navigation field, and meet user requirements.

In addition, the method implements lane-level navigation and positioning. For navigation and positioning in an open scenario of getting on or off an elevated highway, changing a lane, or changing a lane at a highway intersection, precise positioning is implemented, to meet an application requirement of in-vehicle navigation, thereby effectively reducing costs of in-vehicle navigation applications (such as an in-vehicle navigation system and an ETC charging system), increasing related applications in the mobile phone positioning and navigation field, and improving market competitiveness.

In addition, the technical solution of this embodiment may further detect a cycle slip or a half cycle slip that occurs during carrier phase tracking, and perform phase compensation on a phase with a half cycle slip, to improve positioning precision.

A specific process is step 101' of the foregoing embodiment: The positioning chip performs synchronization detection on the satellite signal, and tracks, after completing the synchronization detection, the satellite signal by using a tracking loop, to obtain carrier phase tracking information of the satellite signal, where the carrier phase tracking information includes a carrier phase measurement value.

The following describes in detail "step 101'''" in the foregoing embodiment.

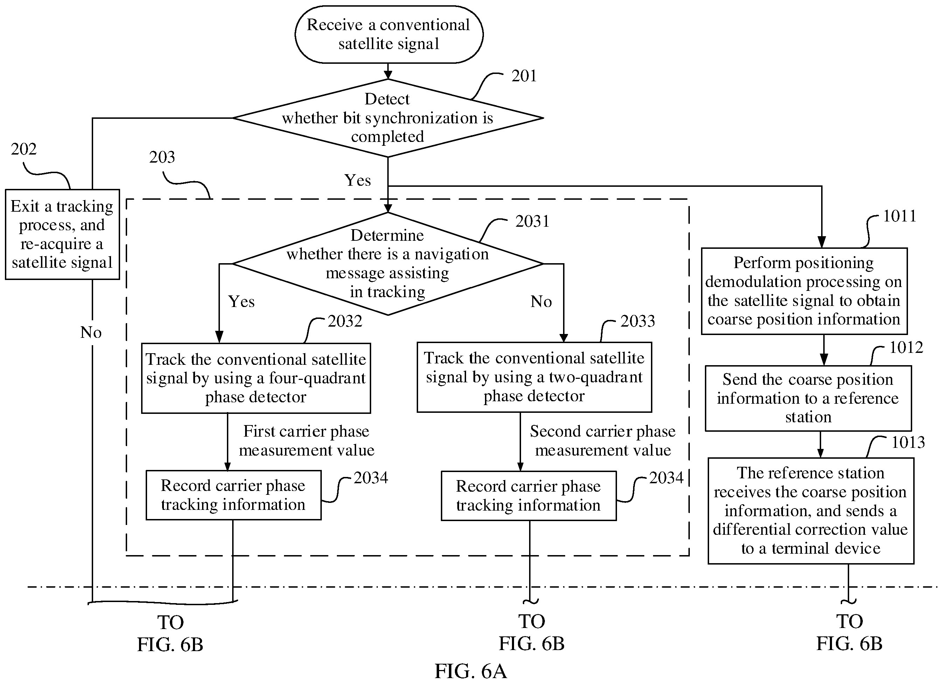

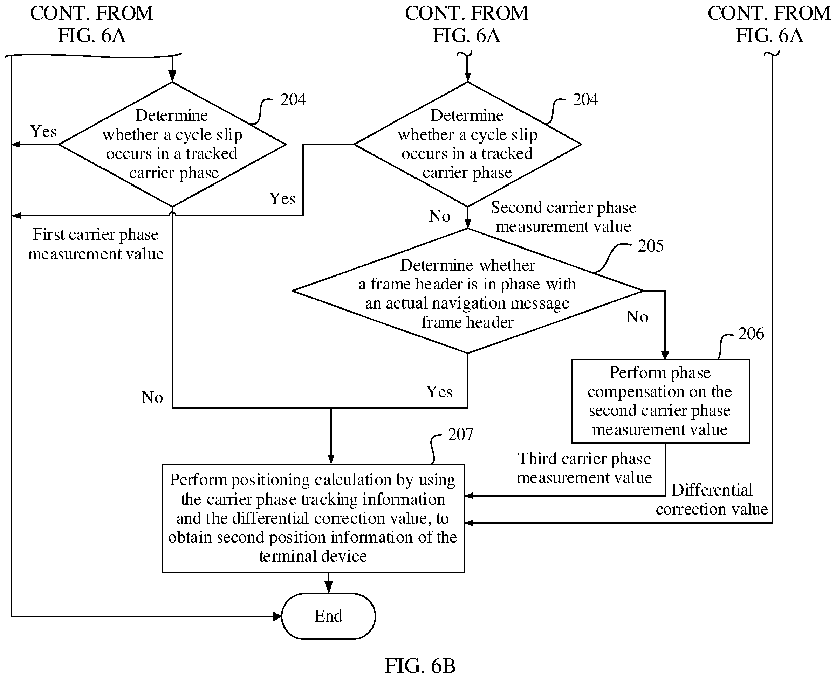

For example, when the satellite signal is a conventional satellite signal, for example, GPSL1C/A, Beidou B1I, QZSSL1CA, or a satellite signal whose carrier frequency is 1575.42 MHz, as shown in FIG. 6A and FIG. 6B, step 101' specifically includes:

> 201. The positioning chip performs synchronization detection on the conventional satellite signal, to detect whether bit synchronization of the conventional satellite signal is completed.

The bit synchronization means that a receiving channel determines, based on a specific algorithm, a position of the current satellite signal in a data bit, or in other words, determines a bit start edge position in the received satellite signal. Further, the positioning chip may receive, through a plurality of channels, conventional satellite signals transmitted by a plurality of GPS satellites, acquire each satellite signal and track the satellite signal. First, bit synchronization of the satellite signal needs to be completed, that is, an edge of a data bit is found in the received satellite signal. Then, frame synchronization is implemented. The frame synchronization means finding a subframe start edge in the satellite signal.

Optionally, the positioning chip may detect, by using a histogram, whether bit synchronization is completed.

202. If no, that is, bit synchronization is not completed, exit the tracking process, and re-acquire a satellite signal.

203. If yes, that is, bit synchronization is completed, perform positioning tracking on the conventional satellite signal.

In addition, the positioning chip further performs positioning calculation on the conventional satellite signal to obtain coarse position information of the terminal device. Specifically, a process in which the positioning chip obtains and sends the coarse position information is the same as step 1011 to step 1013 in the foregoing embodiment, and details are not described herein again.

The foregoing step 203 that the positioning chip performs positioning tracking on the conventional satellite signal specifically includes:

> 2031. Determine whether there is a navigation message assisting in tracking the conventional satellite signal.
> 2032. If yes, that is, there is a navigation message assisting in tracking, track the conventional satellite signal by using a four-quadrant phase detector, to obtain a first carrier phase measurement value.
> 2033. If no, that is, there is no navigation message assisting in tracking, track the conventional satellite signal by using a two-quadrant phase detector, to obtain a second carrier phase measurement value.

When a tracking loop performs positioning tracking on a conventional satellite signal, a phase-locked loop outputs Doppler frequency shift, integral Doppler, and carrier phase measurement values based on a state of a carrier signal duplicated by the tracking loop, and a code tracking loop outputs code phase and pseudorange measurement values based on a state of a C/A code signal duplicated by the code tracking loop. A detector of the carrier loop may additionally demodulate a data bit of a navigation message in the satellite signal.

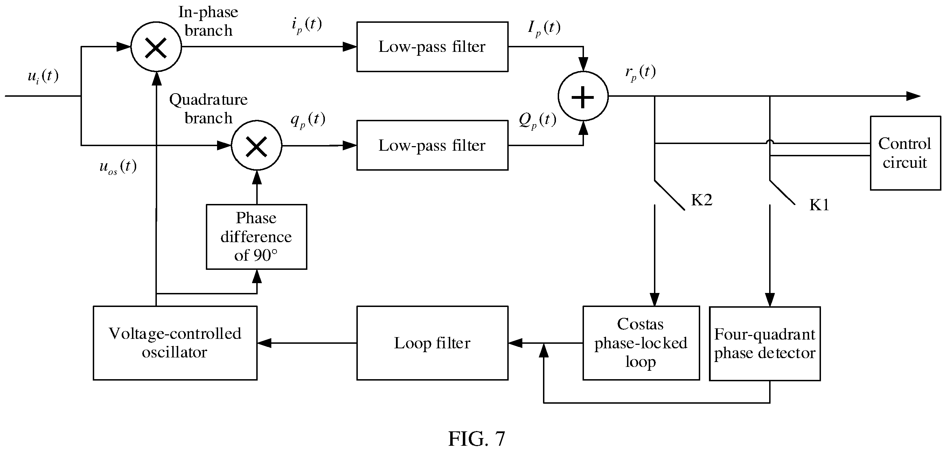

The positioning chip includes a tracking loop, and the tracking loop includes a phase-locked loop. A structure of the phase-locked loop may be similar to the structure shown in FIG. 2e, and includes a phase detector, a loop filter, a voltage-controlled oscillator, and the like. Alternatively, as shown in FIG. 7, the phase-locked loop includes components such as an in-phase branch, a quadrature branch, a control circuit, a first switch K1, a second switch K2, a four-quadrant phase detector, and a two-quadrant phase detector.

Optionally, the two-quadrant phase detector is a costas (costas) phase-locked loop. Specifically, the costas phase-locked loop is a phase-locked loop that can operate with a suitable phase detector for a data bit modulated carrier signal and that is insensitive to a 180° carrier phase change caused by a data bit slip. A difference between the costas phase-locked loop and the four-quadrant phase detector lies in different phase detection ranges. The costas phase-locked loop mainly uses a two-quadrant arctangent function method to perform phase detection, which is a two-quadrant phase detector, whose phase detection range is -90° to +90°. A phase detection range of the four-quadrant phase detector is -180° to +180°.

Generally, the phase range -90° to +90°, or -180° to +180° is referred to as a pull-in range of the phase detector.

When the phase-locked loop is in a locked state, a phase difference between a duplicate carrier and a received carrier is close to zero, and a BPSK modulation mechanism in the satellite signal may cause a data bit level slip of the carrier phase of the received signal, for example, a slip from +1 to -1, or a slip from -1 to +1, leading to a 180° phase slip. For the two-quadrant phase detector, when an actual phase difference is greater than 90°, a phase detection result less than 0° is output. In this case, a phase of a duplicate carrier of the loop is incorrectly adjusted in an opposite direction, which finally results in that the tracking loop is unlocked to the signal. Therefore, to avoid a limitation of the pull-in range of the two-quadrant phase detector, the four-quadrant phase detector with a larger pull-in range is used to perform phase detection.

FIG. 7 is a circuit diagram of a tracking loop, which includes an in-phase branch, a quadrature branch, a four-quadrant phase detector, a two-quadrant phase detector, a first switch K1, a second switch K2, a control circuit, a loop filter, a voltage-controlled oscillator, and the like. K1 is connected to the four-quadrant phase detector, and K2 is connected to the two-quadrant phase detector. The control circuit is configured to control K1 and K2 to be closed or open. Specifically, when the control circuit controls K1 to be closed and K2 to be open, a first tracking loop is formed by the four-quadrant phase detector, the loop filter, and the voltage-controlled oscillator. When K1 is open and K2 is closed, a second tracking loop is formed by the two-quadrant phase detector, the loop filter, and the voltage-controlled oscillator.

In step 2031, when there is a navigation message assisting in tracking, step 2032 is performed: The positioning chip tracks the conventional satellite signal by using the first tracking loop, and outputs the first carrier phase measurement value. When there is no navigation message assisting in tracking, step 2033 is performed: The positioning chip tracks the conventional satellite signal by using the second tracking loop, and outputs the second carrier phase measurement value.

2034. The positioning chip records carrier phase tracking information.

The carrier phase tracking information includes the first carrier phase measurement value or the second carrier phase measurement value, and parameters such as a Doppler frequency shift and an integral Doppler of a local duplicate carrier signal of the positioning chip. In addition, the carrier phase tracking information further includes other information, for example, information such as whether the carrier phase tracking is continuous and whether there is loss of lock, which is subsequently used to determine a cycle slip of the carrier phase.

It should be noted that, when tracking the conventional signal, the positioning chip records a change of the carrier phase in real time, to subsequently detect whether a cycle slip occurs in the phase.

In this embodiment, in the process of tracking the conventional satellite signal, the pull-in range is enlarged by using the four-quadrant phase detector, thereby avoiding a 180° phase ambiguity generated by a data bit slip.

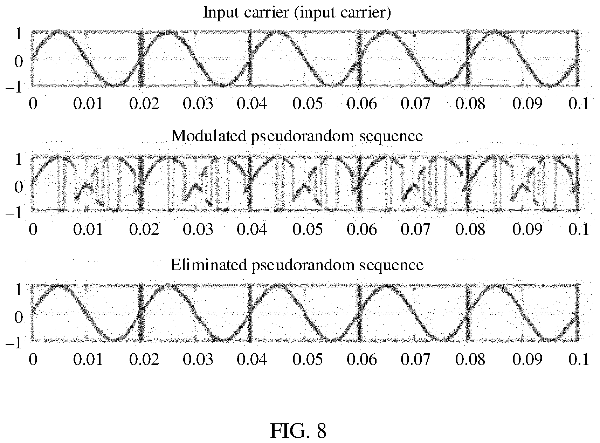

Specifically, as shown in FIG. 8, it is assumed that a pseudorandom sequence is a data bit sequence, for example:

1, 1, 1, 1, 1,-1, 1, 1, -1, -1, 1,-1, 1,-1, 1, 1, -1, -1, -1, 1.

In FIG. 8, the first line represents an input carrier (input carrier) signal, and the second line represents a modulated (modulated) pseudorandom sequence. After the satellite signal is broadcast, the modulated pseudorandom sequence needs to be multiplied by the carrier signal, to obtain an eliminated pseudorandom sequence that is the same as the input carrier signal. In this case, the original data bit sequence is changed to a full 1 sequence:

1, 1, 1, 1, 1, 1, 1, 1, 1, 1, 1, 1, 1, 1, 1, 1, 1, 1, 1.

If the two-quadrant phase detector is used for phase detection, a 180° phase ambiguity is generated. If the four-quadrant phase detector is used for phase detection, a carrier signal that is the same as the input carrier can be obtained because the pull-in range of the four-quadrant phase detector is large, thereby avoiding the 180° phase ambiguity generated when the two-quadrant phase detector is used for phase detection.

After step 203 that the positioning chip performs tracking on the conventional satellite signal, the method further includes:

204. The positioning chip determines whether a cycle slip occurs in a tracked carrier phase.

Specifically, in a possible implementation, for the first carrier phase measurement value output after the signal passes through the first tracking loop, if a cycle slip occurs in a first carrier phase in the carrier phase tracking information, the tracking fails, the process ends, and a satellite signal needs to be re-acquired. If no cycle slip phenomenon occurs, that is, a determining result is "no", step 207 is performed.

In another possible implementation, for the second carrier phase measurement value output after the signal passes through the second tracking loop, if a cycle slip occurs in a second carrier phase in the carrier phase tracking information, the tracking fails, the process ends, and a satellite signal needs to be re-acquired. If no cycle slip phenomenon occurs, that is, a determining result is "no", step 205 is performed.

205. Query for a demodulated frame header of a navigation message in the satellite signal, and determine whether the frame header is in phase with an actual navigation message frame header, that is, detected whether a half cycle slip occurs in the carrier phase.

If yes, that is, the frame header is in phase with the actual navigation message frame header, it indicates that no half cycle slip occurs, and step 207 is performed. If no, that is, the frame header is in reverse phase to the actual navigation message frame header, it indicates that a half cycle slip occurs, and step 206 is performed.

206. Perform phase compensation on the second carrier phase measurement value to obtain a third carrier phase measurement value. For example, a 0.5 cycle phase is added to the phase of the second carrier phase measurement value to repair a 180° phase ambiguity caused by the half cycle slip.

207. Perform positioning calculation by using the carrier phase tracking information and the differential correction value, to obtain second position information of the terminal device. This step is the same as "step 103" in the foregoing embodiment, and specifically includes:

The differential correction value is the measurement value sent by the reference station in step 1013, and includes information such as the carrier phase measurement value, the ionospheric delay, and the tropospheric delay. The carrier phase tracking information includes the first carrier phase measurement value, the second carrier phase measurement value, or the third carrier phase measurement value. Specifically:

207-1 is performed: After step 204, the positioning chip obtains a corrected carrier phase measurement value based on the differential correction value and the first carrier phase measurement value, and performs positioning calculation by using the corrected carrier phase measurement value to obtain the second position information.

Alternatively, 207-2 is performed: After step 205, the positioning chip obtains a corrected carrier phase measurement value based on the differential correction value and the second carrier phase measurement value, and performs positioning calculation by using the corrected carrier phase measurement value to obtain the second position information.

Alternatively, 207-3 is performed: After step 206, the positioning chip obtains a corrected carrier phase measurement value based on the differential correction value and the third carrier phase measurement value, and performs positioning calculation by using the corrected carrier phase measurement value to obtain the second position information.

Further, for a process of obtaining the second position information by using the differential correction value and the carrier phase measurement value, refer to step 103. Details are not described herein again. It should be noted that, in this embodiment, a sequence of the carrier phase tracking process, that is, step 203, and the process of obtaining the coarse position information through demodulation, that is, steps 1011 to 1013, is not limited.

This embodiment provides a method for tracking and processing a conventional satellite signal. When detecting that there is a navigation message assisting in tracking the conventional satellite signal, the positioning chip uses the carrier tracking loop with the four-quadrant phase detector to track the carrier signal, thereby avoiding using the tracking loop with the two-quadrant phase detector to adjust the phase of the duplicate carrier in an opposite direction, which finally results in that the tracking loop is unlocked to the signal.

In addition, the carrier phase tracking information is recorded during carrier phase tracking, and a cycle slip problem generated by the carrier phase measurement value is resolved by detecting whether a cycle slip occurs in the carrier phase. In addition, for half cycle slip repair, a 0.5 cycle phase is added for compensation when it is detected that a half cycle slip occurs in the carrier phase measurement value subsequently. In this way, a 180° phase ambiguity generated when the phase is unlocked is overcome, and a half cycle slip problem generated during duplication of the positioning chip is resolved.

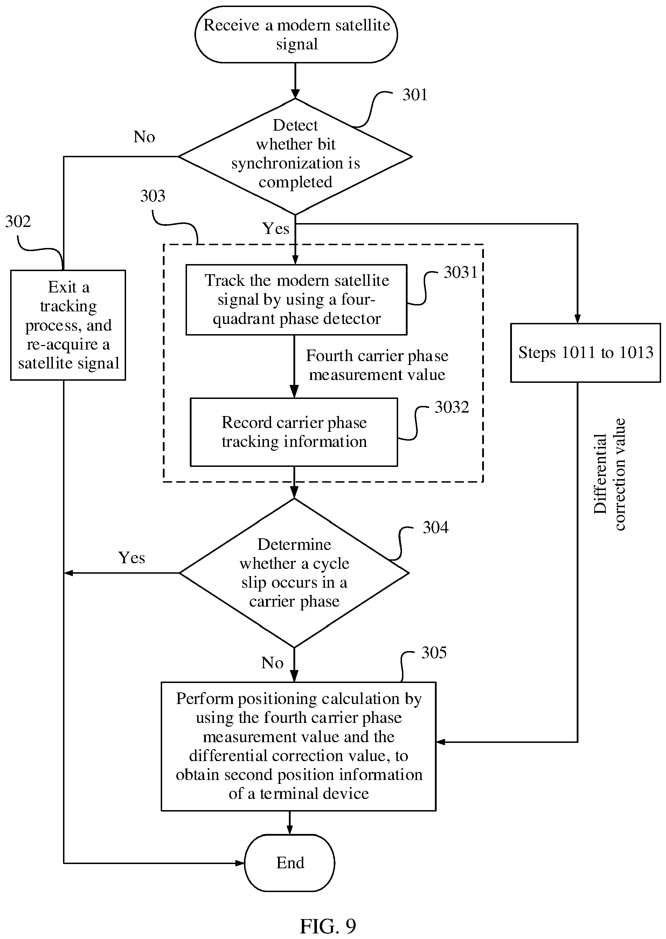

Similarly, when the satellite signal received by the receiving chip in step 101 is a second satellite signal, that is, a modern satellite signal, such as GPSL5, GALE1, GALES, QZSSL5, or BD1C, most of which are close to a frequency band of 1176.42 MHz, and the modern satellite signal includes a data channel (data channel) and a pilot channel (pilot channel), a process of tracking and processing the modern satellite signal is shown in FIG. 9, and specifically includes:

301. The positioning chip detects whether bit synchronization of the modern satellite signal is completed. A specific process is the same as step 201 in the foregoing embodiment, and details are not described herein again.

302. If no, that is, bit synchronization is not completed, exit the tracking process, and re-acquire a satellite signal.

303. If yes, track the modern satellite signal, specifically including:

3031. The positioning chip tracks the modern satellite signal by using the four-quadrant phase detector, where carrier phase tracking information is output after the modern satellite signal is processed by the first tracking loop including the four-quadrant phase detector, and the carrier phase tracking information includes a fourth carrier phase measurement value.

3032. Record the carrier phase tracking information. A specific process is the same as steps 2032 and 2034 in the foregoing embodiment.

304. The positioning chip determines whether a cycle slip occurs in a tracked carrier phase.

If yes, the carrier phase tracking fails, and the process ends. If no, that is, no cycle slip occurs, step 305 is performed.

305. The positioning chip performs positioning calculation by using the differential correction value and the fourth carrier phase measurement value, to obtain second position information of the terminal device.

The differential correction value is the differential correction value sent by the reference station in steps 1011 to 1013 in the foregoing embodiment. For details, refer to the description of the foregoing embodiment. Details are not described herein again. In addition, a processing process of step 305 is also the same as that of step 207 in the foregoing embodiment, and therefore details are not described again.

In this embodiment, in the process of tracking and processing the modern satellite signal, because the modern satellite signal has a data channel and a pilot channel, it is unnecessary to determine whether there is a navigation message assisting in tracking as in the process of tracking the conventional satellite signal, but instead, the pilot channel is directly processed. After the positioning chip detects that bit synchronization of the modern satellite signal is completed, the signal may be directly tracked by using the four-quadrant phase detector, to determine the carrier phase measurement value of the satellite signal.

In addition, the positioning chip further records the carrier phase tracking information during carrier phase tracking, and filters out a signal with a cycle slip, thereby resolving a cycle slip problem generated when differential positioning is performed by using a carrier phase measurement value. For the modern satellite signal, during tracking, the pilot channel is processed, and tracking is performed by using the four-quadrant phase detector and the phase-locked loop, thereby avoiding a half cycle slip phenomenon of the carrier phase.

The following describes an apparatus embodiment corresponding to the foregoing method embodiment.

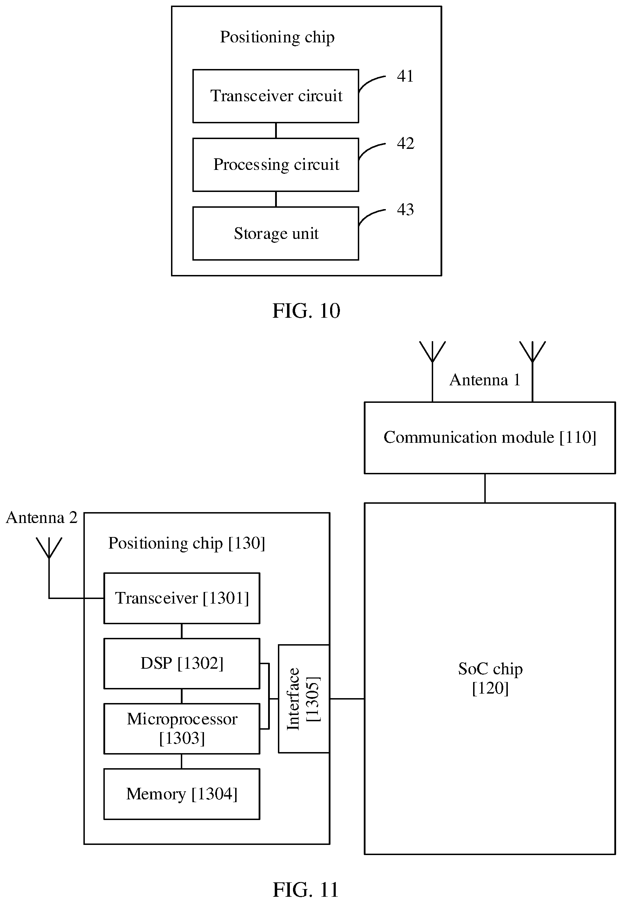

FIG. 10 is a schematic diagram of a structure of a positioning apparatus according to an embodiment of this application. The apparatus may be a terminal device, or may be a positioning chip located in the terminal device. In addition, the apparatus may perform all steps in the positioning method in the foregoing embodiment.

Specifically, as shown in FIG. 10, the apparatus may include a transceiver circuit 41, a processing circuit 42, and a storage unit 43. In addition, the apparatus may further include another unit or module. This is not limited in this application.

The transceiver circuit 41 is configured to receive a satellite signal transmitted by at least one satellite. The processing circuit 42 is configured to: obtain, by using a system on chip SoC chip, a differential correction value sent by a reference station, and perform, based on a carrier phase differential technology, positioning calculation by using the satellite signal and the differential correction value.

Optionally, in a specific implementation of this embodiment, the processing circuit 42 is further configured to: after the positioning chip receives the satellite signal transmitted by the at least one satellite, perform synchronization detection on the satellite signal, and track, after completing the synchronization detection, the satellite signal by using a tracking loop, to obtain carrier phase tracking information of the satellite signal. The processing circuit 42 specifically performs positioning calculation by using the carrier phase tracking information of the satellite signal and the differential correction value, to obtain position information of the terminal device.

Further, the satellite signal transmitted by the at least one satellite includes a first satellite signal, and the processing circuit 42 is specifically configured to determine, after completing the synchronization detection, whether there is a navigation message assisting in tracking; and if there is a navigation message assisting in tracking, track the first satellite signal by using a first tracking loop, where the first tracking loop includes a four-quadrant phase detector, and a first carrier phase measurement value is output after the first satellite signal passes through the four-quadrant phase detector. The processing circuit 42 is further configured to: before performing positioning calculation, determine, based on the first carrier phase measurement value, whether a cycle slip occurs in a carrier phase, and if no cycle slip occurs, perform positioning calculation by using the carrier phase tracking information of the satellite signal and the differential correction value.

Optionally, in another specific implementation of this embodiment, the processing circuit 42 is further configured to: after completing the synchronization detection, if there is no navigation message assisting in tracking, track the first satellite signal by using a second tracking loop, where the second tracking loop includes a two-quadrant phase detector, and a second carrier phase measurement value is output after the first satellite signal passes through the two-quadrant phase detector.

Optionally, the two-quadrant phase detector is a costas (costas) phase-locked loop.

The processing circuit 42 is further configured to: before performing positioning calculation, determine, based on the second carrier phase measurement value, whether a cycle slip occurs in the carrier phase; if no cycle slip occurs in the carrier phase, query for a demodulated frame header of a navigation message in the first satellite signal to determine whether the frame header is in phase with an actual navigation message frame header; and if the frame header is in phase with the actual navigation message frame header, perform positioning calculation by using the carrier phase tracking information of the satellite signal and the differential correction value.

Optionally, in still another specific implementation of this embodiment, the processing circuit 42 is further configured to: when determining that the frame header is not in phase with the actual navigation message frame header, perform phase compensation on the second carrier phase measurement value to obtain a third carrier phase measurement value. The processing circuit 42 is specifically configured to perform positioning calculation by using the third carrier phase measurement value and the differential correction value.

Optionally, if the satellite signal transmitted by the at least one satellite includes a second satellite signal, the processing circuit 42 is specifically configured to track the second satellite signal by using a first tracking loop, where the first tracking loop includes a four-quadrant phase detector, and a fourth carrier phase measurement value is output after the second satellite signal passes through the four-quadrant phase detector.

In addition, the processing circuit 42 is further configured to: before performing positioning calculation, determine, based on the fourth carrier phase measurement value, whether a cycle slip occurs in a carrier phase, and if no cycle slip occurs, perform positioning calculation by using the carrier phase tracking information of the satellite signal and the differential correction value.

Optionally, in still another specific implementation of this embodiment, the processing circuit 42 is further configured to: after the satellite signal transmitted by the at least one satellite is received, perform demodulation processing on the received satellite signal to obtain coarse position information of the terminal device; and the transceiver circuit 41 is further configured to send the coarse position information to the reference station, so that the reference station feeds back the differential correction value based on the coarse position information.

Optionally, the differential correction value includes a carrier phase measurement value of a common-view satellite signal, and the common-view satellite signal is a satellite signal jointly tracked by the positioning chip and the reference station. The processing circuit 42 is specifically configured to perform differential calculation by using the carrier phase measurement value of the common-view satellite signal and the first carrier phase measurement value to obtain a first cycle integer ambiguity; determine a corrected carrier phase measurement value by using the first cycle integer ambiguity; and perform positioning calculation based on the corrected carrier phase measurement value to obtain the position information of the terminal device.

In addition, at a specific hardware implementation level, an embodiment provides a terminal device. As shown in FIG. 11, the terminal device includes: a communication module 110, a SoC chip 120, and a positioning chip 130. In addition, the SoC chip 120 and the positioning chip 130 are connected by using a communication interface. The communication module 110 and the SoC chip 120 may be connected by using a communication bus.

The communication module 110 is configured to establish a communication channel, so that the terminal device is connected to a network by using the communication channel, to implement communication and transmission between the terminal device and another device. The communication module 110 may be a module that completes a transceiver function, for example, may include a communication module such as a wireless local area network (wireless local area network, WLAN) module, a Bluetooth module, or a baseband (baseband) module, and a radio frequency (radio frequency, RF) circuit corresponding to the communication apparatus, configured for wireless local area network communication, Bluetooth communication, infrared communication, and/or cellular communication system communication, for example, wideband code division multiple access (wideband code division multiple access, WCDMA) and/or high speed downlink packet access (high speed downlink packet access, HSDPA). In addition, the communication module 110 supports direct memory access (direct memory access).

Further, the communication module 110 includes various transceiver modules, such as a transceiver and an antenna, for example, an antenna 1. In addition, the communication module 110 may further include components such as a pre-amplifier, a down-converter, an A/D converter, and a baseband processor. In different implementations of this application, the transceiver modules in the communication module 110 generally appear in a form of an integrated circuit (integrated circuit), and may be combined selectively, and not all of the transceiver modules and corresponding antenna groups are necessarily included. For example, the communication module 110 may further include a radio frequency chip and a corresponding antenna, to provide a communication function in a cellular communication system for access to a communication network.

In this embodiment, the communication module 110 is configured to receive a differential correction value sent by a reference station, and transmit the differential correction value to the SoC chip 120.

The positioning chip 130 is configured to implement functions such as tracking processing and positioning calculation on a satellite signal. Specifically, the positioning chip 130 includes a transceiver 1301, a digital signal processor (digital processor signal, DSP) 1302, a microprocessor 1303, a memory 1304, an interface 1305, and the like.

The transceiver 1301 may be configured to receive a satellite signal transmitted by at least one GPS satellite, for example, a conventional satellite signal and a modern satellite signal. The transceiver 1301 includes at least one antenna, for example, an antenna 2, and receives the satellite signal by using the antenna 2, which is filtered and amplified by a pre-filter and a pre-amplifier, and then mixed with a sine wave local oscillator signal generated by a local oscillator to be down-converted into an intermediate frequency (Intermediate Frequency, IF) signal. Finally, an analog-to-digital (Analog-to-Digital, A/D) converter converts the intermediate frequency signal into a discrete-time digital intermediate frequency signal.

The DSP 1302 may include components such as a digital signal processor and a tracking loop. The digital signal processor duplicates, by using the digital intermediate frequency signal output by the radio frequency (RF) front-end, a local carrier and a local pseudocode signal consistent with the received satellite signal, to implement acquisition and tracking of the GPS satellite signal. At a GPS satellite signal transmit end, a GPS carrier signal is modulated with a C/A code and a navigation message data bit. Correspondingly, at a GPS signal receive end, to demodulate a navigation message data bit from a received satellite signal, a baseband digital signal processor needs to completely strip a carrier including a Doppler frequency shift in a digital intermediate frequency signal by mixing, and completely strip a C/A code in the signal by a C/A code correlation operation. A remaining signal is a BPSK modulated navigation message data bit.

The tracking loop is configured to track a GPS signal, and continuously modulate a carrier duplicated inside the tracking loop, so that a phase of the duplicate carrier is consistent with a carrier phase in the digital intermediate frequency signal, thereby implementing carrier stripping.

Specifically, the tracking loop includes a control circuit, a four-quadrant phase detector, a phase-locked loop, a loop filter, a voltage-controlled oscillator, and a first switch. One end of the first switch is connected to the control circuit, and the other end is connected to the four-quadrant phase detector. The four-quadrant phase detector is sequentially connected to the loop filter and the voltage-controlled oscillator. When there is a navigation message assisting in tracking the satellite signal, the control circuit controls the first switch to be closed, to track the satellite signal by using a first tracking loop including the four-quadrant phase detector, the loop filter, and the voltage-controlled oscillator.

In addition, the tracking loop further includes a two-quadrant phase detector and a second switch. One end of the second switch is connected to the control circuit, and the other end is connected to the two-quadrant phase detector. The two-quadrant phase detector is sequentially connected to the loop filter and the voltage-controlled oscillator. When there is no navigation message assisting in tracking the satellite signal, the control circuit controls the second switch to be closed and the first switch to be open, to track the satellite signal by using a second tracking loop including the two-quadrant phase detector, the loop filter, and the voltage-controlled oscillator.

The microprocessor 1303 is configured to perform differential positioning calculation to obtain precise position information of the terminal device. Optionally, the microprocessor 1303 includes a positioning and navigation module and at least one interface 1305. The positioning and navigation module is also referred to as a position calculation module, and the module is mainly configured to perform calculation on a position, a velocity, and a time (PVT) for a receiver, and after the calculation, report information such as the position and the velocity to an operating system of the terminal device through an interface. Optionally, the interface 1305 is a Google Google interface.

In addition, the microprocessor 1303 may further include an inertial navigation module. The module mainly performs data exchange and assistance with the position calculation module by using sensors such as a velocimeter and an accelerometer, to further improve navigation performance. Common assistance manners include loose coupling, tight coupling, and deep coupling.

Optionally, the positioning chip 130 is a GNSS positioning chip.

The memory 1304 may include a volatile memory (volatile memory), for example, a random access memory (Random Access Memory, RAM), or may include a non-volatile memory (non-volatile memory), for example, a flash memory (flash memory), a hard disk drive (Hard Disk Drive, HDD), or a solid-state drive (Solid-State Drive, SSD), or may include a combination of the foregoing types of memories. The memory may store a program or code, and the microprocessor may implement a function of the terminal device by executing the program or code. In addition, the memory 1304 may exist independently, or may be integrated with the microprocessor 1303.

It should be understood that the positioning chip 130 may alternatively be used as a processor. The processor may connect parts of the entire terminal device by using various interfaces and lines, and execute various functions of the terminal device and/or process data by running or executing a software program and/or unit stored in the memory 1304, and invoking data stored in the memory 1304. Further, the processor may include an integrated circuit (Integrated Circuit, IC), for example, may include a single packaged IC, or may include a plurality of packaged ICs that are connected and that have a same function or different functions. For example, the processor may include only a combination of a central processing unit (central processing unit, CPU) and a control chip (for example, a baseband chip) in the transceiver.

In addition, the terminal device may alternatively include more or fewer components, or some components may be combined, or a different component may be used. This is not limited in this embodiment of this application.

In this embodiment, when the terminal device is used as a GPS receiver, the method steps shown in FIG. 5, FIG. 6A and FIG. 6B, and FIG. 9 in the foregoing embodiments may be implemented. In addition, in the embodiment shown in FIG. 10, a function of the transceiver circuit 41 may be implemented by the DSP 1302 and the antenna 2, a function to be implemented by the processing circuit 42 may be implemented by the DSP 1302, and a function of the storage unit 43 may be implemented by the memory 1304.

According to the method provided in this application, a DSP and a microprocessor are integrated in a GNSS positioning chip, so that satellite signal tracking and calculation are implemented on a positioning chip side to obtain a carrier phase measurement value, and whether a cycle slip occurs in a carrier phase is learned from recorded carrier phase tracking information. The method uses an RTK technology to perform positioning calculation, which has strong real-time performance and low algorithm complexity.

In addition, an embodiment of this application further provides a computer storage medium. The computer storage medium may store a program. When the program is executed, some or all of the steps in the embodiments of the positioning method provided in this application may be included. The storage medium may be a magnetic disk, an optical disc, a read-only memory ROM, a random access memory RAM, or the like.

All or some of the foregoing embodiments may be implemented through software, hardware, firmware, or any combination thereof. When software is used to implement the embodiments, all or a part of the embodiments may be implemented in a form of a computer program product.

The computer program product includes one or more computer instructions, for example, a signal receiving instruction, a signal tracking instruction, and a sending instruction. When a computer loads and executes the computer program instructions, all or some of the method processes or functions described in the foregoing embodiments of this application are generated.

The computer may be a general-purpose computer, a dedicated computer, a computer network, or another programmable apparatus. The computer instructions may be stored in a computer-readable storage medium, or transmitted from one computer-readable storage medium to another computer-readable storage medium. The computer-readable storage medium may be any usable medium accessible by the computer, or a storage device, such as a server or a data center, integrating one or more usable media. The usable medium may be a magnetic medium such as a floppy disk, a hard disk, or a magnetic tape, an optical medium (for example, a DVD), or a semiconductor medium such as a solid-state drive SSD.

In the specification, claims, and accompanying drawings of this application, the terms "first", "second", and so on are intended to distinguish between similar objects but do not necessarily indicate a specific order or sequence. In addition, the term "including", "comprising", or any other variant thereof is intended to cover a non-exclusive inclusion.

In this specification, identical or similar parts in the embodiments may be obtained with reference to each other. Particularly, the terminal device and apparatus embodiments are basically similar to the method embodiments, and therefore are described briefly. For related parts, refer to the descriptions in the method embodiments.

The foregoing implementations of this application are not intended to limit the protection scope of this application.

## Claims

1. A positioning method, wherein the method is applied to a terminal device, the terminal device comprises a positioning chip and a system on chip SoC chip, and the method comprises:

   receiving, by the positioning chip, a satellite signal transmitted by at least one satellite;
   obtaining, by the positioning chip by using the SoC chip, a differential correction value sent by a reference station; and
   performing, by the positioning chip based on a carrier phase differential technology, positioning calculation by using the satellite signal and the differential correction value.

2. The method according to claim 1, wherein after the receiving, by the positioning chip, a satellite signal transmitted by at least one satellite, the method further comprises:

   performing, by the positioning chip, synchronization detection on the satellite signal, and tracking, after completing the synchronization detection, the satellite signal by using a tracking loop, to obtain carrier phase tracking information of the satellite signal; and
   the performing positioning calculation by using the satellite signal and the differential correction value comprises:
   performing positioning calculation by using the carrier phase tracking information of the satellite signal and the differential correction value, to obtain position information of the terminal device.

3. The method according to claim 2, wherein the satellite signal transmitted by the at least one satellite comprises a first satellite signal;

   the tracking, after completing the synchronization detection, the satellite signal by using a tracking loop, to obtain carrier phase tracking information of the satellite signal comprises:

   determining, after completing the synchronization detection, whether there is a navigation message assisting in tracking; and
   if there is a navigation message assisting in tracking, tracking the first satellite signal by using the first tracking loop, wherein the first tracking loop comprises a four-quadrant phase detector, and a first carrier phase measurement value is output after the first satellite signal passes through the four-quadrant phase detector; and
   before the performing positioning calculation by using the carrier phase tracking information of the satellite signal and the differential correction value, the method further comprises:
   determining, based on the first carrier phase measurement value, whether a cycle slip occurs in a carrier phase, and if no cycle slip occurs, performing the foregoing step of performing positioning calculation by using the carrier phase tracking information of the satellite signal and the differential correction value.

**4.** The method according to claim 3, wherein the method further comprises:

after the synchronization detection is completed, if there is no navigation message assisting in tracking, tracking the first satellite signal by using a second tracking loop, wherein the second tracking loop comprises a two-quadrant phase detector, and a second carrier phase measurement value is output after the first satellite signal passes through the two-quadrant phase detector; and
before the performing positioning calculation by using the carrier phase tracking information of the satellite signal and the differential correction value, the method further comprises:

determining, based on the second carrier phase measurement value, whether a cycle slip occurs in the carrier phase;
if no cycle slip occurs in the carrier phase, querying for a demodulated frame header of a navigation message in the first satellite signal to determine whether the frame header is in phase with an actual navigation message frame header; and
if the frame header is in phase with the actual navigation message frame header, performing the foregoing step of performing positioning calculation by using the carrier phase tracking information of the satellite signal and the differential correction value.

**5.** The method according to claim 4, wherein the method further comprises:

if determining that the frame header is not in phase with the actual navigation message frame header, performing phase compensation on the second carrier phase measurement value to obtain a third carrier phase measurement value; and
the performing positioning calculation by using the carrier phase tracking information of the satellite signal and the differential correction value comprises:
performing positioning calculation by using the third carrier phase measurement value and the differential correction value.

**6.** The method according to claim 2, wherein the satellite signal transmitted by the at least one satellite comprises a second satellite signal;
the tracking, after completing the synchronization detection, the satellite signal by using a tracking loop, to obtain carrier phase tracking information of the satellite signal comprises:

tracking the second satellite signal by using a first tracking loop, wherein the first tracking loop comprises a four-quadrant phase detector, and a fourth carrier phase measurement value is output after the second satellite signal passes through the four-quadrant phase detector; and
before the performing positioning calculation by using the carrier phase tracking information of the satellite signal and the differential correction value, the method further comprises:
determining, based on the fourth carrier phase measurement value, whether a cycle slip occurs in a carrier phase, and if no cycle slip occurs, performing the step of performing positioning calculation by using the carrier phase tracking information of the satellite signal and the differential correction value.

**7.** The method according to any one of claims 1 to 6, wherein after the receiving, by the positioning chip, a satellite signal transmitted by at least one satellite, the method further comprises:

performing, by the positioning chip, demodulation processing on the satellite signal to obtain coarse position information of the terminal device; and
sending the coarse position information to the reference station, so that the reference station feeds back the differential correction value based on the coarse position information.

**8.** The method according to claim 3, wherein the differential correction value comprises a carrier phase measurement value of a common-view satellite signal, and the common-view satellite signal is a satellite signal jointly tracked by the terminal device and the reference station; and
the performing the step of performing positioning calculation by using the carrier phase tracking information of the satellite signal and the differential correction value comprises:

performing differential calculation by using the carrier phase measurement value of the common-view satellite signal and the first carrier phase measurement value to obtain a first cycle integer ambiguity;

determining a corrected carrier phase measurement value by using the first cycle integer ambiguity; and performing positioning calculation based on the corrected carrier phase measurement value to obtain the position information of the terminal device.

9. A positioning chip, comprising:

a transceiver circuit, configured to receive a satellite signal transmitted by at least one satellite; and a processing circuit, configured to obtain, by using a system on chip SoC chip, a differential correction value sent by a reference station, and perform, based on a carrier phase differential technology, positioning calculation by using the satellite signal and the differential correction value.

10. The positioning chip according to claim 9, wherein

the processing circuit is further configured to: after the transceiver circuit receives the satellite signal transmitted by the at least one satellite, perform synchronization detection on the satellite signal, and track, after completing the synchronization detection, the satellite signal by using a tracking loop, to obtain carrier phase tracking information of the satellite signal; and the processing circuit specifically performs positioning calculation by using the carrier phase tracking information of the satellite signal and the differential correction value, to obtain position information of the terminal device.

11. The positioning chip according to claim 10, wherein the satellite signal transmitted by the at least one satellite comprises a first satellite signal;

the processing circuit is specifically configured to determine, after completing the synchronization detection, whether there is a navigation message assisting in tracking; and if there is a navigation message assisting in tracking, track the first satellite signal by using a first tracking loop, wherein the first tracking loop comprises a four-quadrant phase detector, and a first carrier phase measurement value is output after the first satellite signal passes through the four-quadrant phase detector; and the processing circuit is further configured to: before performing positioning calculation, determine, based on the first carrier phase measurement value, whether a cycle slip occurs in a carrier phase; and if no cycle slip occurs, perform positioning calculation by using the carrier phase tracking information of the satellite signal and the differential correction value.

12. The positioning chip according to claim 11, wherein

the processing circuit is further configured to: after the synchronization detection is completed, if there is no navigation message assisting in tracking, track the first satellite signal by using the second tracking loop, wherein the second tracking loop comprises a two-quadrant phase detector, and a second carrier phase measurement value is output after the first satellite signal passes through the two-quadrant phase detector; and the processing circuit is further configured to: before performing positioning calculation, determine, based on the second carrier phase measurement value, whether a cycle slip occurs in the carrier phase; if no cycle slip occurs in the carrier phase, query for a demodulated frame header of a navigation message in the first satellite signal to determine whether the frame header is in phase with an actual navigation message frame header; and if the frame header is in phase with the actual navigation message frame header, perform positioning calculation by using the carrier phase tracking information of the satellite signal and the differential correction value.

13. The positioning chip according to claim 12, wherein

the processing circuit is further configured to: if determining that the frame header is not in phase with the actual navigation message frame header, perform phase compensation on the second carrier phase measurement value to obtain a third carrier phase measurement value; and the processing circuit is specifically configured to perform positioning calculation by using the third carrier phase measurement value and the differential correction value.

14. The positioning chip according to claim 10, wherein the satellite signal transmitted by the at least one satellite comprises a second satellite signal;

the processing circuit is specifically configured to track the second satellite signal by using a first tracking loop, wherein the first tracking loop comprises a four-quadrant phase detector, and a fourth carrier phase measurement value is output after the second satellite signal passes through the four-quadrant phase detector; and
the processing circuit is further configured to: before performing positioning calculation, determine, based on the fourth carrier phase measurement value, whether a cycle slip occurs in a carrier phase, and if no cycle slip occurs, perform positioning calculation by using the carrier phase tracking information of the satellite signal and the differential correction value.

15. The positioning chip according to any one of claims 9 to 14, wherein

the processing circuit is further configured to: after the satellite signal transmitted by the at least one satellite is received, perform demodulation processing on the satellite signal to obtain coarse position information of the terminal device; and
the transceiver circuit is further configured to: send the coarse position information to the reference station, so that the reference station feeds back the differential correction value based on the coarse position information.

16. The positioning chip according to claim 11, wherein the differential correction value comprises a carrier phase measurement value of a common-view satellite signal, and the common-view satellite signal is a satellite signal jointly tracked by the positioning chip and the reference station; and
the processing circuit is specifically configured to perform differential calculation by using the carrier phase measurement value of the common-view satellite signal and the first carrier phase measurement value to obtain a first cycle integer ambiguity; determine a corrected carrier phase measurement value by using the first cycle integer ambiguity; and perform positioning calculation based on the corrected carrier phase measurement value to obtain the position information of the terminal device.

17. A tracking loop, comprising: a control circuit, a four-quadrant phase detector, a phase-locked loop, a loop filter, a voltage-controlled oscillator, and a first switch, wherein

one end of the first switch is connected to the control circuit, and the other end is connected to the four-quadrant phase detector;
the four-quadrant phase detector is sequentially connected to the loop filter and the voltage-controlled oscillator; and
when there is a navigation message assisting in tracking a satellite signal, the control circuit controls the first switch to be closed, to track the satellite signal by using a first tracking loop comprising the four-quadrant phase detector, the loop filter, and the voltage-controlled oscillator.

18. The tracking loop according to claim 17, further comprising a two-quadrant phase detector and a second switch, wherein

one end of the second switch is connected to the control circuit, and the other end is connected to the two-quadrant phase detector;
the two-quadrant phase detector is sequentially connected to the loop filter and the voltage-controlled oscillator; and
when there is no navigation message assisting in tracking the satellite signal, the control circuit controls the second switch to be closed and the first switch to be open, to track the satellite signal by using a second tracking loop comprising the two-quadrant phase detector, the loop filter, and the voltage-controlled oscillator.

19. A terminal device, comprising a positioning chip and a system on chip SoC chip, wherein

the SoC chip is configured to send a differential correction value from a reference station to the positioning chip; and
the positioning chip comprises a processing circuit, and when executing a computer program stored in a memory, the processing circuit implements the method according to any one of claims 1 to 8.

20. A computer-readable storage medium, comprising instructions, wherein when the instructions are run on a computer, the computer is enabled to perform the method according to any one of claims 1 to 8.

21. A computer program product, wherein when the computer program product runs on a computer, the computer is enabled to perform the method according to any one of claims 1 to 8.

System such as IOS or Android

GNSS positioning chip

PVT module

Inertial navigation module

Acquisition and tracking module

Mobile phone antenna

FIG. 1

Space constellation part

Ground monitoring part                     User equipment part

FIG. 2a

Satellite

$\approx 300\ m$

S

$\lambda/2$

A

B

$\lambda \approx 19\ cm$

$(N + 0.5)\lambda$

...

...

Phase of a
ranging code

Carrier phase                    Receiver

R

FIG. 2b

FIG. 2c

FIG. 2d

EP 4 141 490 A1

FIG. 2e

FIG. 2f

Quadrature branch

$Q_p(t)$    First quadrant

Fourth quadrant

$r_p = I_p + jQ_p$

$\phi_c(t)$

$I_p(t)$

O

In-phase branch

Third quadrant                Second quadrant

FIG. 2g

FIG. 3

Satellite 1        Satellite 2        Satellite 3

Satellite signal

Coarse position
information

Differential
correction value

Reference
station

Terminal
device/mobile
station

Positioning
chip

FIG. 4

A positioning chip receives a satellite signal transmitted by at least one satellite

101

The positioning chip obtains, by using a SoC chip, a differential correction value sent by a reference station

102

The positioning chip performs, based on a carrier phase differential technology, positioning calculation by using the satellite signal and the differential correction value

103

FIG. 5

EP 4 141 490 A1

Receive a conventional
satellite signal

Detect
whether bit synchronization is
completed — 201

202

Exit a tracking
process, and
re-acquire a
satellite signal

No

203

Yes

Determine
whether there is a navigation
message assisting
in tracking — 2031

Yes

2032

Track the conventional satellite
signal by using a four-quadrant
phase detector

First carrier phase
measurement value

Record carrier phase
tracking information — 2034

No

2033

Track the conventional satellite
signal by using a two-quadrant
phase detector

Second carrier phase
measurement value

Record carrier phase
tracking information — 2034

1011

Perform positioning
demodulation processing on
the satellite signal to obtain
coarse position information

1012

Send the coarse position
information to a reference
station

1013

The reference station
receives the coarse position
information, and sends a
differential correction value
to a terminal device

TO
FIG. 6B

TO
FIG. 6B

TO
FIG. 6B

FIG. 6A

CONT. FROM
FIG. 6A

CONT. FROM
FIG. 6A

CONT. FROM
FIG. 6A

Yes ← Determine whether a cycle slip occurs in a tracked carrier phase 204

Yes →

First carrier phase measurement value

Determine whether a cycle slip occurs in a tracked carrier phase 204

No | Second carrier phase measurement value

Determine whether a frame header is in phase with an actual navigation message frame header 205

No →

Perform phase compensation on the second carrier phase measurement value 206

No

Yes

Perform positioning calculation by using the carrier phase tracking information and the differential correction value, to obtain second position information of the terminal device 207

Third carrier phase measurement value

Differential correction value

End

FIG. 6B

EP 4 141 490 A1

In-phase branch

$u_i(t)$

$u_{os}(t)$

$i_p(t)$

Low-pass filter

$I_p(t)$

Quadrature branch

$q_p(t)$

Low-pass filter

$Q_p(t)$

$r_p(t)$

Control circuit

K2

K1

Phase difference of 90°

Voltage-controlled oscillator

Loop filter

Costas phase-locked loop

Four-quadrant phase detector

FIG. 7

EP 4 141 490 A1

Input carrier (input carrier)

Modulated pseudorandom sequence

Eliminated pseudorandom sequence

FIG. 8

Receive a modern satellite
signal

301

No ← Detect
whether bit
synchronization is
completed

303

302

Yes

Exit a
tracking
process, and
re-acquire a
satellite signal

Track the modern satellite
signal by using a four-
quadrant phase detector

3031

Fourth carrier phase
measurement value

Steps 1011 to 1013

Record carrier phase
tracking information

3032

Differential
correction value

304

Yes ← Determine
whether a cycle
slip occurs in a
carrier phase

No

305

Perform positioning calculation by
using the fourth carrier phase
measurement value and the
differential correction value, to
obtain second position information
of a terminal device

End

FIG. 9

Positioning chip

Transceiver circuit — 41

Processing circuit — 42

Storage unit — 43

FIG. 10

Antenna 1

Communication module [110]

Antenna 2

Positioning chip [130]

Transceiver [1301]

DSP [1302]

Microprocessor [1303]

Memory [1304]

Interface [1305]

SoC chip [120]

FIG. 11

## INTERNATIONAL SEARCH REPORT

| International application No. |
| --- |
| **PCT/CN2020/090446** |

**A. CLASSIFICATION OF SUBJECT MATTER**

G01S 19/43(2010.01)i

According to International Patent Classification (IPC) or to both national classification and IPC

**B. FIELDS SEARCHED**

Minimum documentation searched (classification system followed by classification symbols)

G01S; H04W; H04B; G01C; G06F

Documentation searched other than minimum documentation to the extent that such documents are included in the fields searched

Electronic data base consulted during the international search (name of data base and, where practicable, search terms used)

CNPAT, CNKI, EPODOC, WPI, WOTXT, USTXT, EPTXT: 华为, 定位, 终端, 手机, 芯片, 片上, 系统, 卫星, 导航, 接收, 基准, 基站, 差分, 动态, 校正, 跟踪, 同步, 粗略, 架构, 亚米, RTK, soc, original, correction, calibration, location, terminal, handset, chip, system, satellite, navigation, receive, base, station, difference, dynamics, track, trace, coarse, construct

**C. DOCUMENTS CONSIDERED TO BE RELEVANT**

| Category* | Citation of document, with indication, where appropriate, of the relevant passages | Relevant to claim No. |
| --- | --- | --- |
| X | CN 105372688 A (GUANGZHOU HI-TARGET SURVEYING INSTRUMENT CO., LTD.) 02 March 2016 (2016-03-02) description, paragraphs [0028]-[0059], and figures 1-4 | 1, 9, 19-21 |
| X | CN 104754729 A (SHANGHAI PATEO YUEZHEN NETWORKING TECHNOLOGY SERVICE CO., LTD.) 01 July 2015 (2015-07-01) description, paragraphs [0034]-[0049], and figures 1-2 | 1, 9, 19-21 |
| A | CN 104345323 A (ANYKA (GUANGZHOU) MICROELECTRONICS TECHNOLOGY CO., LTD.) 11 February 2015 (2015-02-11) description, paragraphs [0025]-[0069], and figures 1-3 | 1-21 |
| A | CN 107831510 A (JIAXING GLEAD ELECTRONICS CO., LTD.) 23 March 2018 (2018-03-23) entire document | 1-21 |
| A | CN 205656311 U (JIANGSU BDS APPLICATION INDUSTRY INSTITUTE CO., LTD.) 19 October 2016 (2016-10-19) entire document | 1-21 |

☑ Further documents are listed in the continuation of Box C.  ☑ See patent family annex.

| | | |
| --- | --- | --- |
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
| --- | --- |
| **25 January 2021** | **18 February 2021** |

| Name and mailing address of the ISA/CN | Authorized officer |
| --- | --- |
| **China National Intellectual Property Administration (ISA/ CN)** **No. 6, Xitucheng Road, Jimenqiao, Haidian District, Beijing 100088 China** | |
| Facsimile No. **(86-10)62019451** | Telephone No. |

Form PCT/ISA/210 (second sheet) (January 2015)

## INTERNATIONAL SEARCH REPORT

International application No.

**PCT/CN2020/090446**

**C.    DOCUMENTS CONSIDERED TO BE RELEVANT**

| Category* | Citation of document, with indication, where appropriate, of the relevant passages | Relevant to claim No. |
|---|---|---|
| A | CN 105607079 A (SOUTHEAST UNIVERSITY) 25 May 2016 (2016-05-25)<br>entire document | 1-21 |
| A | CN 111123318 A (TECHTOTOP MICROELECTRONICS CO., LTD.) 08 May 2020 (2020-05-08)<br>entire document | 1-21 |
| A | CN 205280943 U (GUILIN UNIVERSITY OF ELECTRONIC TECHNOLOGY) 01 June 2016 (2016-06-01)<br>entire document | 1-21 |
| A | CN 206258588 U (GUANGZHOU ZHONGHAIDA SURVEYING INSTRUMENT CO., LTD.) 16 June 2017 (2017-06-16)<br>entire document | 1-21 |
| A | CN 109116380 A (SHANGHAI HUACE NAVIGATION TECHNOLOGY CO., LTD.) 01 January 2019 (2019-01-01)<br>entire document | 1-21 |
| A | CN 101813760 A (ANYKA (GUANGZHOU) MICROELECTRONICS TECHNOLOGY CO., LTD.) 25 August 2010 (2010-08-25)<br>entire document | 1-21 |
| A | US 7574215 B1 (TRIMBLE NAVIGATION LIMITED) 11 August 2009 (2009-08-11)<br>entire document | 1-21 |

Form PCT/ISA/210 (second sheet) (January 2015)

**INTERNATIONAL SEARCH REPORT**
Information on patent family members

International application No.

**PCT/CN2020/090446**

| Patent document cited in search report | | | Publication date (day/month/year) | Patent family member(s) | | | Publication date (day/month/year) |
|---|---|---|---|---|---|---|---|
| CN | 105372688 | A | 02 March 2016 | None | | | |
| CN | 104754729 | A | 01 July 2015 | None | | | |
| CN | 104345323 | A | 11 February 2015 | None | | | |
| CN | 107831510 | A | 23 March 2018 | None | | | |
| CN | 205656311 | U | 19 October 2016 | None | | | |
| CN | 105607079 | A | 25 May 2016 | None | | | |
| CN | 111123318 | A | 08 May 2020 | None | | | |
| CN | 205280943 | U | 01 June 2016 | None | | | |
| CN | 206258588 | U | 16 June 2017 | None | | | |
| CN | 109116380 | A | 01 January 2019 | None | | | |
| CN | 101813760 | A | 25 August 2010 | CN | 101813760 | B | 25 July 2012 |
| US | 7574215 | B1 | 11 August 2009 | CA | 2361086 | A1 | 06 May 2002 |
| | | | | EP | 1203965 | A2 | 08 May 2002 |

Form PCT/ISA/210 (patent family annex) (January 2015)